# EUROPEAN PATENT APPLICATION

(11) **EP 4 632 026 A1**
(43) Date of publication of application: **15.10.2025**
(21) Application number: 23900603.4
(22) Date of filing: 04.12.2023
(51) Int. Cl.: C09D 201/00, C08G 59/26, C08G 65/326, C09D 7/63, G03F 7/11, G03F 7/20, H01L 21/312

(54) **COMPOSITION FOR FORMING PROTECTIVE FILM**

(30) Priority: 05.12.2022 JP 2022194224
(71) Applicant: Nissan Chemical Corporation, Tokyo 103-6119 (JP)
(72) Inventor: NISHITA, Tokio, Toyama-shi, Toyama 939-2792 (JP); KAMIBAYASHI, Satoshi, Toyama-shi, Toyama 939-2792 (JP); KUBODERA, Shun, Toyama-shi, Toyama 939-2792 (JP)
(74) Representative: Hoffmann Eitle
(86) International application number: PCT/JP2023/043231
(87) International publication number: WO 2024/122488

(57) **Abstract**

A protective-film forming composition against a semiconductor wet etching solution, containing: component (A): a film-forming component; component (B): at least one of a triazole compound (B-1), a tetrazole compound (B-2), a compound (B-3) having two or more phenolic hydroxy groups, and a compound (B-4) having two or more non-phenolic hydroxy groups; and component (C): a solvent.

## Description

### Technical Field

The present invention relates to a composition for forming a protective film excellent in resistance particularly to a semiconductor wet etching solution in a lithography process in semiconductor manufacturing. The present invention also relates to a protective film formed of the composition, a method for manufacturing a substrate with a resist pattern to which the protective film is applied, and a method for manufacturing a semiconductor device.

### Background Art

In semiconductor manufacturing, a lithography process of providing a resist underlayer film between a substrate and a resist film formed the substrate and forming a resist pattern having a desired shape is widely known. The substrate is processed after the resist pattern is formed, and dry etching is mainly used as the process, but wet etching may be used depending on the type of substrate. Patent Literature 1 discloses a resist underlayer film material having resistance to alkaline hydrogen peroxide water.

### Citation List

### Patent Literature

Patent Literature 1: JP 2018-173520 A

### Summary of Invention

### Technical Problem

In a case where a protective film for a semiconductor substrate is formed by using a protective-film forming composition, and a base substrate is processed by wet etching, with the protective film used as an etching mask, it is demanded for the protective film to have a good masking function (that is, the masked part can protect the substrate) against a semiconductor wet etching solution.

Furthermore, the protective film used for the above object is expected to have a function as a resist underlayer film for solving a trouble (shape defect or the like) at the time of forming a so-called resist pattern.

The present invention has been made in view of the above circumstances, and an object of the present invention is to provide a composition for forming a protective film that can form a protective film having excellent resistance to a semiconductor wet etching solution, and can also be effectively used as a composition for forming a resist underlayer film.

### Solution to Problem

As a result of intensive studies to solve the above-described problems, the present inventors have found that the above-described problems can be solved by including a specific component (A) and a specific component (B) in a protective-film forming composition, and have completed the present invention.

That is, the present invention includes the following aspects.
[1] A protective-film forming composition against a semiconductor wet etching solution, containing:
   component (A): a film-forming component;
   component (B): at least one of a triazole compound (B-1), a tetrazole compound (B-2), a compound (B-3) having two or more phenolic hydroxy groups, and a compound (B-4) having two or more non-phenolic hydroxy groups; and
   component (C): a solvent.
[2] The protective-film forming composition according to [1], wherein the component (A) includes a compound having a theoretical molecular weight of 999 or less.
[3] The protective-film forming composition according to [2], wherein the compound having a theoretical molecular weight of 999 or less is a compound having a theoretical molecular weight of 999 or less represented by the following Formula (1): 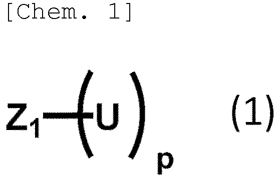
   wherein Z₁ represents a p-valent group containing a nitrogen-containing heterocyclic ring,
   p represents an integer of 2 to 4, and
   each U independently represents a monovalent organic group represented by the following Formula (2), 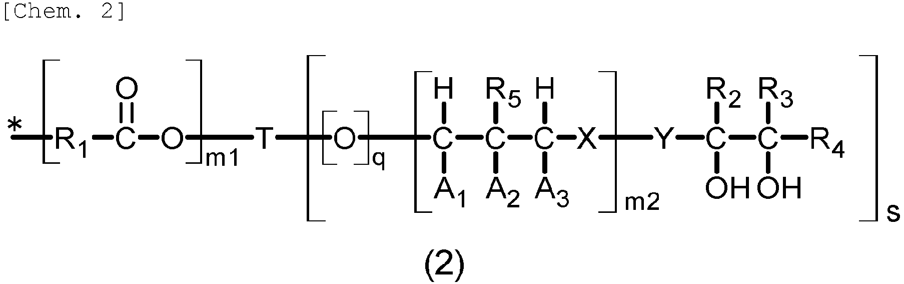
   wherein R₁ represents an alkylene group having 1 to 4 carbon atoms,
   T represents a single bond or a (s+1)-valent hydrocarbon group having 1 to 8 carbon atoms,
   A₁ to A₃ each independently represent a hydrogen atom, a methyl group, or an ethyl group,
   X represents -COO-, -OCO-, -O-, -S-, or -NRₐ-, and Rₐ represents a hydrogen atom or a methyl group,
   Y represents a single bond or an alkylene group having 1 to 4 carbon atoms which may be substituted,
   R₂, R₃, and R₄ each independently represent a hydrogen atom or an alkyl group having 1 to 10 carbon atoms or an aryl group having 6 to 40 carbon atoms which may be substituted,
   R₅ represents a hydrogen atom or a hydroxy group,
   m1, m2, and q each independently represent an integer of 0 or 1,
   s represents an integer of 1 or 2, and
   * represents a bonding moiety to Z₁ in Formula (1),
   provided that, when T is a single bond, m1 and q are not simultaneously 1.
[4] The protective-film forming composition according to [3], wherein Z₁ is represented by the following Formula (3-1) or (3-2): 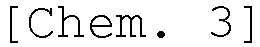 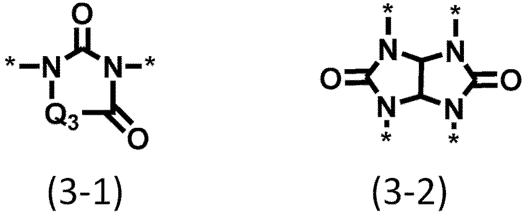
   wherein Q₃ represents the following Formula (4), (5), (6), or (7), and
   each * represents a bonding moiety to U in Formula (1), 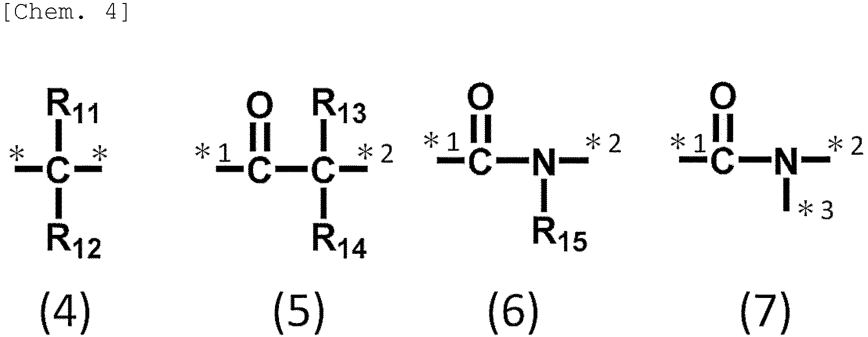
   wherein R₁₁ to R₁₅ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, and the phenyl group may be substituted with at least one monovalent functional group selected from the group consisting of an alkyl group having 1 to 6 carbon atoms, a halogen atom, an alkoxy group having 1 to 10 carbon atoms, a nitro group, a cyano group, and an alkylthio group having 1 to 6 carbon atoms,
   * represents a bonding hand, *1 represents a bonding hand bonded to a nitrogen atom in Formula (3-1), *2 represents a bonding hand bonded to a carbon atom in Formula (3-1), and *3 represents a bonding moiety to U in Formula (1).
[5] The protective-film forming composition according to any one of [1] to [4], wherein the triazole compound (B-1) is at least one of a compound represented by the following Formula (B-1-1), a compound represented by the following Formula (B-1-2), a compound represented by the following Formula (B-1-3), and a compound represented by the following Formula (B-1-4): 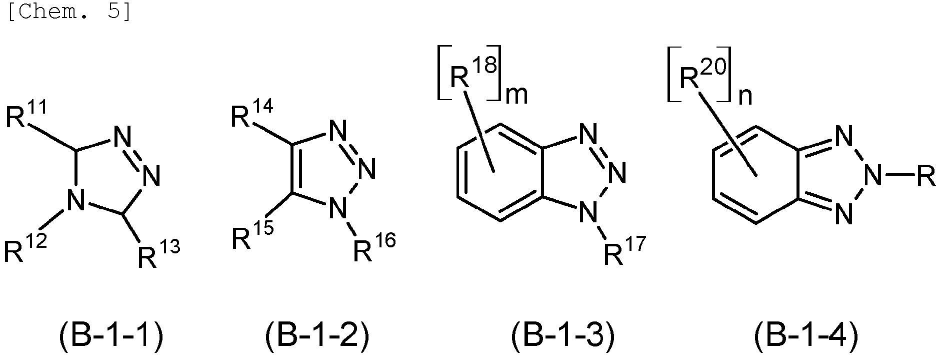
   wherein R¹¹ to R²⁰ each independently represent a group formed by one or two or more atoms selected from the group consisting of a hydrogen atom, a carbon atom, an oxygen atom, a nitrogen atom, a sulfur atom, a phosphorus atom, a silicon atom, and a halogen atom,
   R¹⁴ and R¹⁵ may be bonded to each other to form a ring structure,
   m and n each independently represent an integer of 0 to 4,
   when m is 2 or more, two or more R¹⁸s may be the same as or different from each other, and
   when n is 2 or more, two or more R²⁰s may be the same as or different from each other.
[6] The protective-film forming composition according to any one of [1] to [5], wherein the tetrazole compound (B-2) is a compound represented by the following Formula (B-2-1): 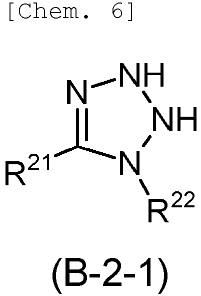
   wherein R²¹ and R²² each independently represent a group formed by one or two or more atoms selected from the group consisting of a hydrogen atom, a carbon atom, an oxygen atom, a nitrogen atom, a sulfur atom, a phosphorus atom, a silicon atom, and a halogen atom, and
   R²¹ and R²² may be bonded to each other to form a ring structure.
[7] The protective-film forming composition according to any one of [1] to [6], wherein the compound (B-3) is at least one of a compound (B-3-1) represented by the following Formula (11a), a compound (B-3-2) represented by the following Formula (11b), and a compound (B-3-3) having a group represented by the following Formula (12) and a molecular weight of 300 or more and less than 800 or a compound having a weight average molecular weight of 300 or more and less than 800. 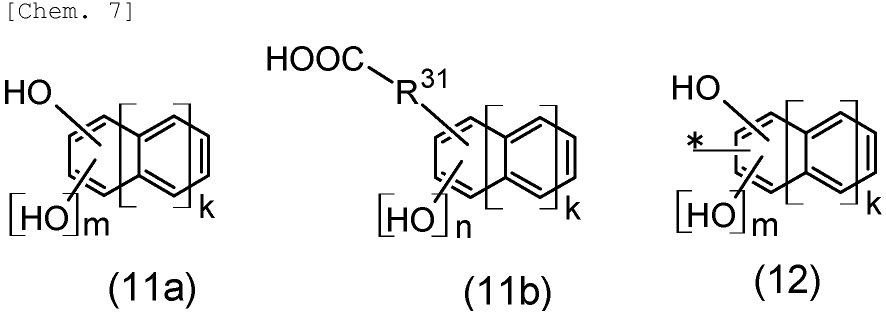
   wherein R³¹ represents a single bond, an alkylene group having 1 to 4 carbon atoms, or an alkenylene group having 2 to 4 carbon atoms,
   k represents an integer of 0 or 1,
   m represents an integer of 1 to 3,
   n represents an integer of 2 to 4, and
   * represents a bonding hand.
[8] The protective-film forming composition according to any one of [1] to [7], wherein the compound (B-4) having two or more non-phenolic hydroxy groups is a compound represented by the following Formula (B-4-1): 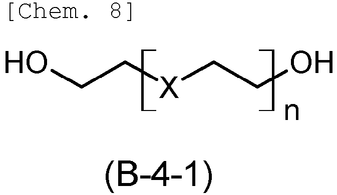
   wherein X represents -O- or -NR- (R represents a hydrogen atom, an alkyl group having 1 to 6 carbon atoms which may have a hydroxy group, an aryl group having 6 to 12 carbon atoms which may have a substituent, or an aralkyl group having 7 to 13 carbon atoms which may have a substituent), and
   n represents an integer of 1 to 3, and when n is 2 or 3, Xs may be the same as or different from each other.
[9] A protective film against a semiconductor wet etching solution, wherein the protective film includes a baked product of a coating film formed of the protective-film forming composition according to any one of [1] to [8].
[10] A method for manufacturing a substrate with a protective film used in semiconductor manufacturing, the method including: a step of applying the protective-film forming composition according to any one of [1] to [8] onto a stepped semiconductor substrate and baking the protective-film forming composition to form a protective film.
[11] A method for manufacturing a substrate with a resist pattern used in semiconductor manufacturing, the method including:
   a step of applying the protective-film forming composition according to any one of [1] to [8] on a semiconductor substrate and baking the protective-film forming composition to form a protective film as a resist underlayer film; and
   a step of forming a resist film directly on the protective film or over the protective film, with another layer interposed between the resist film and the protective film, and exposing and developing the resist film to form a resist pattern.
[12] A method for manufacturing a semiconductor device, the method including a step of forming a protective film by using the protective-film forming composition according to any one of [1] to [8] on a semiconductor substrate having a surface on which an inorganic film is formed, forming a resist pattern directly on the protective film or over the protective film, with another layer interposed between the resist pattern and the protective film, dry etching the protective film by using the resist pattern as a mask to expose a surface of the inorganic film, and performing wet etching on the inorganic film by using the protective film after the dry etching as a mask with a semiconductor wet etching solution.

### Advantageous Effects of Invention

According to the present invention, it is possible to provide a composition for forming a protective film that can form a protective film having excellent resistance to a semiconductor wet etching solution, and can also be effectively used as a composition for forming a resist underlayer film.

### Description of Embodiments

### (Protective-film Forming Composition)

A protective-film forming composition of the present invention is a composition for forming a protective film.

The protective film is preferably a protective film that protects an inorganic film formed on a surface of a semiconductor substrate from wet etching.

The protective-film forming composition contains a component (A), a component (B), and a component (C): a solvent.

The component (A) is a film-forming component.

The component (B) is at least one of a triazole compound (B-1), a tetrazole compound (B-2), a compound (B-3) having two or more phenolic hydroxy groups, and a compound (B-4) having two or more non-phenolic hydroxy groups.

The component (C) is a solvent.

### <Component (A)>

The component (A) is a film-forming component.

The film-forming component is not particularly limited as long as it is, for example, a compound that forms a film by being applied onto a substrate and heated, but is preferably a compound having a theoretical molecular weight of 999 or less.

More preferably, the film-forming component is a compound represented by the following Formula (1) and having a theoretical molecular weight of 999 or less: 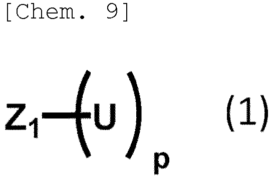
wherein Z₁ represents a p-valent group containing a nitrogen-containing heterocyclic ring,
p represents an integer of 2 to 4, and
each U independently represents a monovalent organic group represented by the following Formula (2), 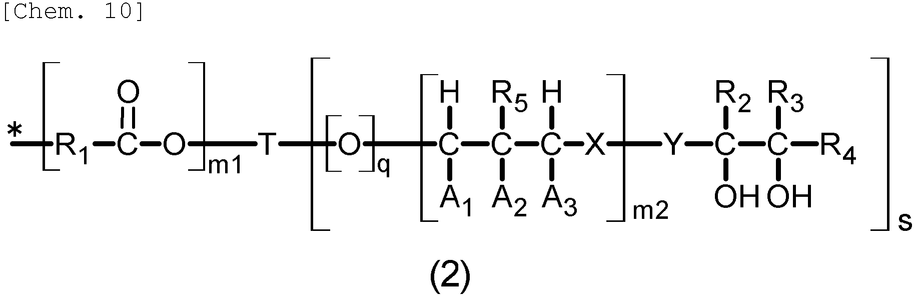
wherein R₁ represents an alkylene group having 1 to 4 carbon atoms,
T represents a single bond or a (s+1)-valent hydrocarbon group having 1 to 8 carbon atoms,
A₁ to A₃ each independently represent a hydrogen atom, a methyl group, or an ethyl group,
X represents -COO-, -OCO-, -O-, -S-, or -NRₐ-, and Rₐ represents a hydrogen atom or a methyl group,
Y represents a single bond or an alkylene group having 1 to 4 carbon atoms which may be substituted,
R₂, R₃, and R₄ each independently represent a hydrogen atom or an alkyl group having 1 to 10 carbon atoms or an aryl group having 6 to 40 carbon atoms which may be substituted,
R₅ represents a hydrogen atom or a hydroxy group,
m1, m2, and q each independently represent an integer of 0 or 1,
s represents an integer of 1 or 2, and
* represents a bonding moiety to Z₁ in Formula (1),
provided that, when T is a single bond, m1 and q are not simultaneously 1.

The theoretical molecular weight refers to a molecular weight calculated by calculation based on the chemical structure of the compound represented by Formula (1).

From the viewpoint of increasing the dry etching rate, the compound represented by Formula (1) preferably contains 2 or more, 3 or more, or 4 or more nitrogen atoms and 6 or more, 8 or more, 9 or more, 10 or more, or 15 or more oxygen atoms in the molecule. The compound preferably further contains 2 or more, 3 or more, 4 or more, 5 or more, or 6 or more sulfur atoms in the molecule.

m2 in Formula (2) is preferably 1.

When s in Formula (2) is 2, q is preferably 1.

X in Formula (2) is preferably -S-.

For example, when s is 1, m1 is 0 or 1, m2 is 1, T is a single bond or an alkylene group having 1 to 8 carbon atoms, and q is 0 or 1. However, when T is a single bond, m1 and q are not simultaneously 1.

For example, when s is 2, m1 is 1, m2 is 1, T is a trivalent hydrocarbon group having 1 to 8 carbon atoms, and q is 1.

In the present specification, examples of the alkylene group include a methylene group, an ethylene group, a 1,3-propylene group, a 1-methylethylene group, a 1,4-butylene group, a 1-ethylethylene group, a 1-methylpropylene group, a 2-methylpropylene group, a 1,5-pentylene group, a 1-methylbutylene group, a 2-methylbutylene group, a 1,1-dimethylpropylene group, a 1,2-dimethylpropylene group, a 1-ethylpropylene group, a 2-ethylpropylene group, a 1,6-hexylene group, a 1,4-cyclohexylene group, a 1,8-octylene group, a 2-ethyloctylene group, a 1,9-nonylene group, and a 1,10-decylene group.

Regarding Y in Formula (2), the phrase "which may be substituted" means that some or all hydrogen atoms present in the functional group to be substituted may be substituted with, for example, a hydroxy group, a halogen atom, a carboxyl group, a nitro group, a cyano group, a methylenedioxy group, an acetoxy group, a methylthio group, an amino group, or an alkoxy group having 1 to 9 carbon atoms.

In the present specification, examples of the aryl group include a phenyl group, an o-methylphenyl group, an m-methylphenyl group, a p-methylphenyl group, an o-chlorophenyl group, an m-chlorophenyl group, a p-chlorophenyl group, an o-fluorophenyl group, a p-fluorophenyl group, an o-methoxyphenyl group, a p-methoxyphenyl group, a p-nitrophenyl group, a p-cyanophenyl group, an α-naphthyl group, a β-naphthyl group, an o-biphenylyl group, an m-biphenylyl group, a p-biphenylyl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group.

In Formula (1), Z₁ is preferably represented by the following Formula (3-1) or (3-2): 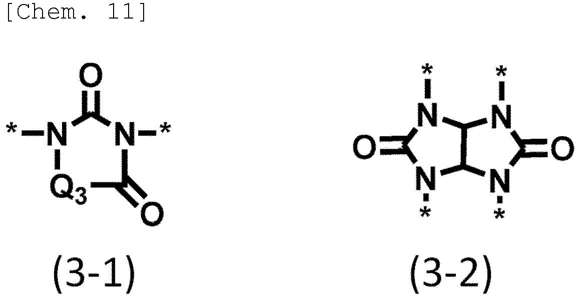
wherein Q₃ represents the following Formula (4), (5), (6), or (7), and
each * represents a bonding moiety to U in Formula (1), 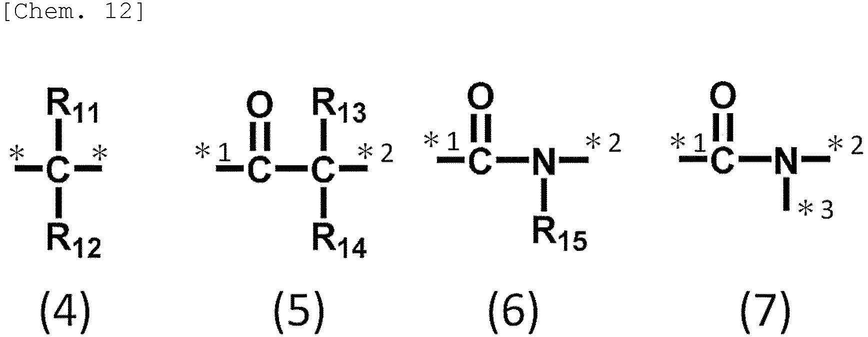
wherein R₁₁ to R₁₅ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, and the phenyl group may be substituted with at least one monovalent functional group selected from the group consisting of an alkyl group having 1 to 6 carbon atoms, a halogen atom, an alkoxy group having 1 to 10 carbon atoms, a nitro group, a cyano group, and an alkylthio group having 1 to 6 carbon atoms,
* represents a bonding hand, *1 represents a bonding hand bonded to a nitrogen atom in Formula (3-1), *2 represents a bonding hand bonded to a carbon atom in Formula (3-1), and *3 represents a bonding moiety to U in Formula (1).

In the present specification, examples of the alkyl group include a methyl group, an ethyl group, an n-propyl group, an i-propyl group, a cyclopropyl group, an n-butyl group, an i-butyl group, an s-butyl group, a t-butyl group, a cyclobutyl group, a 1-methyl-cyclopropyl group, a 2-methyl-cyclopropyl group, an n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, an n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, a 2-ethyl-3-methyl-cyclopropyl group, and a decyl group.

In the present specification, examples of the alkenyl group include a 1-propenyl group, a 2-propenyl group, a 1-methyl-1-ethenyl group, a 1-butenyl group, a 2-butenyl group, a 3-butenyl group, a 2-methyl-1-propenyl group, a 2-methyl-2-propenyl group, a 1-ethylethenyl group, a 1-methyl-1-propenyl group, a 1-methyl-2-propenyl group, a 1-pentenyl group, a 2-pentenyl group, a 3-pentenyl group, a 4-pentenyl group, a 1-n-propylethenyl group, a 1-methyl-1-butenyl group, a 1-methyl-2-butenyl group, a 1-methyl-3-butenyl group, a 2-ethyl-2-propenyl group, a 2-methyl-1-butenyl group, a 2-methyl-2-butenyl group, a 2-methyl-3-butenyl group, a 3-methyl-1-butenyl group, a 3-methyl-2-butenyl group, a 3-methyl-3-butenyl group, a 1,1-dimethyl-2-propenyl group, a 1-i-propylethenyl group, a 1,2-dimethyl-1-propenyl group, a 1,2-dimethyl-2-propenyl group, a 1-cyclopentenyl group, a 2-cyclopentenyl group, a 3-cyclopentenyl group, a 1-hexenyl group, a 2-hexenyl group, a 3-hexenyl group, a 4-hexenyl group, a 5-hexenyl group, a 1-methyl-1-pentenyl group, a 1-methyl-2-pentenyl group, a 1-methyl-3-pentenyl group, a 1-methyl-4-pentenyl group, a 1-n-butylethenyl group, a 2-methyl-1-pentenyl group, a 2-methyl-2-pentenyl group, a 2-methyl-3-pentenyl group, a 2-methyl-4-pentenyl group, a 2-n-propyl-2-propenyl group, a 3-methyl-1-pentenyl group, a 3-methyl-2-pentenyl group, a 3-methyl-3-pentenyl group, a 3-methyl-4-pentenyl group, a 3-ethyl-3-butenyl group, a 4-methyl-1-pentenyl group, a 4-methyl-2-pentenyl group, a 4-methyl-3-pentenyl group, a 4-methyl-4-pentenyl group, a 1,1-dimethyl-2-butenyl group, a 1,1-dimethyl-3-butenyl group, a 1,2-dimethyl-1-butenyl group, a 1,2-dimethyl-2-butenyl group, a 1,2-dimethyl-3-butenyl group, a 1-methyl-2-ethyl-2-propenyl group, a 1-s-butylethenyl group, a 1,3-dimethyl-1-butenyl group, a 1,3-dimethyl-2-butenyl group, a 1,3-dimethyl-3-butenyl group, a 1-i-butylethenyl group, a 2,2-dimethyl-3-butenyl group, a 2,3-dimethyl-1-butenyl group, a 2,3-dimethyl-2-butenyl group, a 2,3-dimethyl-3-butenyl group, a 2-i-propyl-2-propenyl group, a 3,3-dimethyl-1-butenyl group, a 1-ethyl-1-butenyl group, a 1-ethyl-2-butenyl group, a 1-ethyl-3-butenyl group, a 1-n-propyl-1-propenyl group, a 1-n-propyl-2-propenyl group, a 2-ethyl-1-butenyl group, a 2-ethyl-2-butenyl group, a 2-ethyl-3-butenyl group, a 1,1,2-trimethyl-2-propenyl group, a 1-t-butylethenyl group, a 1-methyl-1-ethyl-2-propenyl group, a 1-ethyl-2-methyl-1-propenyl group, a 1-ethyl-2-methyl-2-propenyl group, a 1-i-propyl-1-propenyl group, a 1-i-propyl-2-propenyl group, a 1-methyl-2-cyclopentenyl group, a 1-methyl-3-cyclopentenyl group, a 2-methyl-1-cyclopentenyl group, a 2-methyl-2-cyclopentenyl group, a 2-methyl-3-cyclopentenyl group, a 2-methyl-4-cyclopentenyl group, a 2-methyl-5-cyclopentenyl group, a 2-methylene-cyclopentyl group, a 3-methyl-1-cyclopentenyl group, a 3-methyl-2-cyclopentenyl group, a 3-methyl-3-cyclopentenyl group, a 3-methyl-4-cyclopentenyl group, a 3-methyl-5-cyclopentenyl group, a 3-methylene-cyclopentyl group, a 1-cyclohexenyl group, a 2-cyclohexenyl group, and a 3-cyclohexenyl group.

In the present specification, examples of the alkynyl group include an ethynyl group, a 1-propynyl group, a 2-propynyl group, a 1-butynyl group, a 2-butynyl group, and a 3-butynyl group.

In the present specification, examples of a halogen atom include a fluorine atom, a chlorine atom, a bromine atom, and an iodine atom.

In the present specification, examples of the alkoxy group include a methoxy group, an ethoxy group, an n-propoxy group, an i-propoxy group, an n-butoxy group, an i-butoxy group, an s-butoxy group, a t-butoxy group, an n-pentoxy group, a 1-methyl-n-butoxy group, a 2-methyl-n-butoxy group, a 3-methyl-n-butoxy group, a 1,1-dimethyl-n-propoxy group, a 1,2-dimethyl-n-propoxy group, a 2,2-dimethyl-n-propoxy group, a 1-ethyl-n-propoxy group, an n-hexyloxy group, a 1-methyl-n-pentyloxy group, a 2-methyl-n-pentyloxy group, a 3-methyl-n-pentyloxy group, a 4-methyl-n-pentyloxy group, a 1,1-dimethyl-n-butoxy group, a 1,2-dimethyl-n-butoxy group, a 1,3-dimethyl-n-butoxy group, a 2,2-dimethyl-n-butoxy group, a 2,3-dimethyl-n-butoxy group, a 3,3-dimethyl-n-butoxy group, a 1-ethyl-n-butoxy group, a 2-ethyl-n-butoxy group, a 1,1,2-trimethyl-n-propoxy group, a 1,2,2-trimethyl-n-propoxy group, a 1-ethyl-1-methyl-n-propoxy group, a 1-ethyl-2-methyl-n-propoxy group, an n-heptyloxy group, an n-octyloxy group, and an n-nonyloxy group.

In the present specification, examples of an alkylthio group include a methylthio group, an ethylthio group, and a butylthio group.

In Formula (3-1), when Q₃ represents Formula (4), it is preferable that R₁₁ and R₁₂ in Formula (4) are each independently an alkyl group having 1 to 10 carbon atoms.

In Formula (3-1), when Q₃ represents Formula (5), it is preferable that R₁₃ and R₁₄ in Formula (5) are each independently an alkyl group having 1 to 10 carbon atoms.

Z₁ in Formula (1) is preferably Formula (3-1).

Q₃ in Formula (3-1) is preferably Formula (6) or (7).

R₁₅ in Formula (6) is preferably an alkyl group having 1 to 10 carbon atoms which may be interrupted by an oxygen atom or a sulfur atom, or an alkenyl group having 2 to 10 carbon atoms which may be interrupted by an oxygen atom or a sulfur atom, and is more preferably an alkyl group having 1 to 10 carbon atoms or an alkenyl group having 2 to 10 carbon atoms.

The compound represented by Formula (1) can be obtained, for example, by reacting an epoxy group or an allyl group of the compounds represented by the following Formulae (a) to (ak) with 1-thioglycerol (3-mercapto-1,2-propanediol, CAS No. 96-27-5) by a known method, but is not limited thereto. It may contain a diol structure by hydrolysis of the epoxy group of the compound. A diol structure derived from the reaction of the epoxy group or allyl group with 1-thioglycerol is preferable, and a diol structure derived from the reaction of the epoxy group with 1-thioglycerol is more preferable.

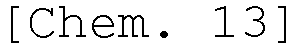

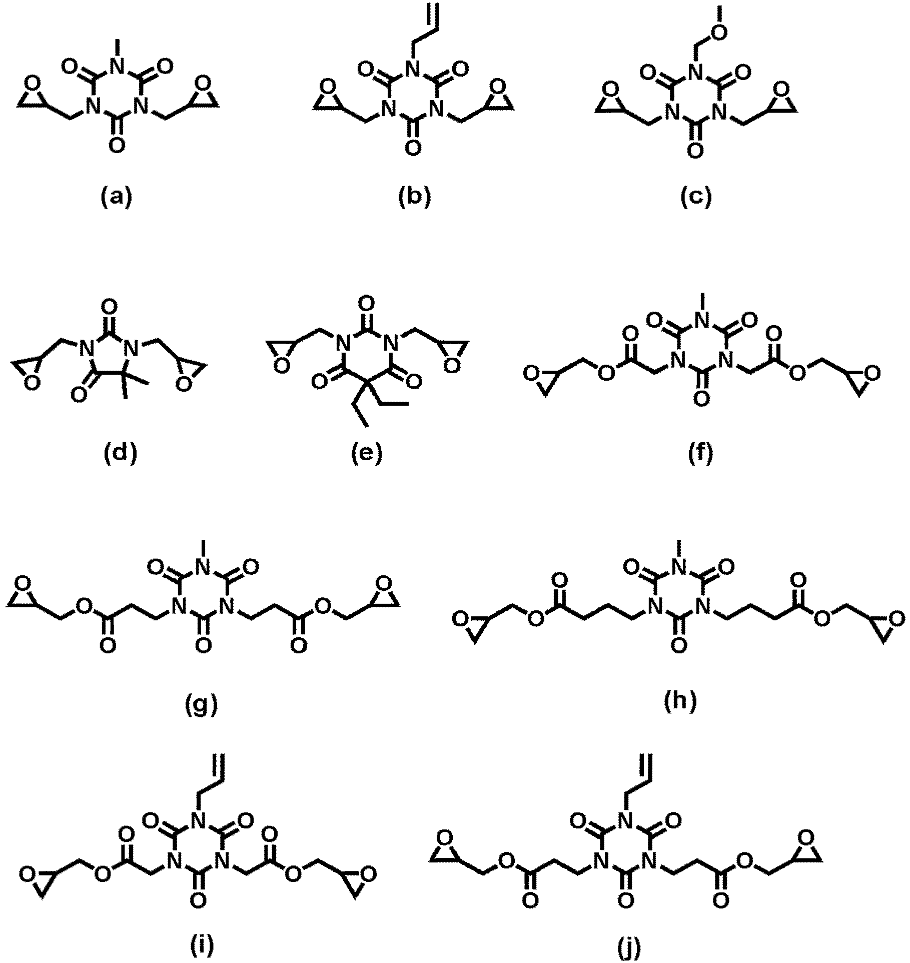

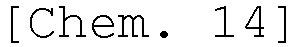

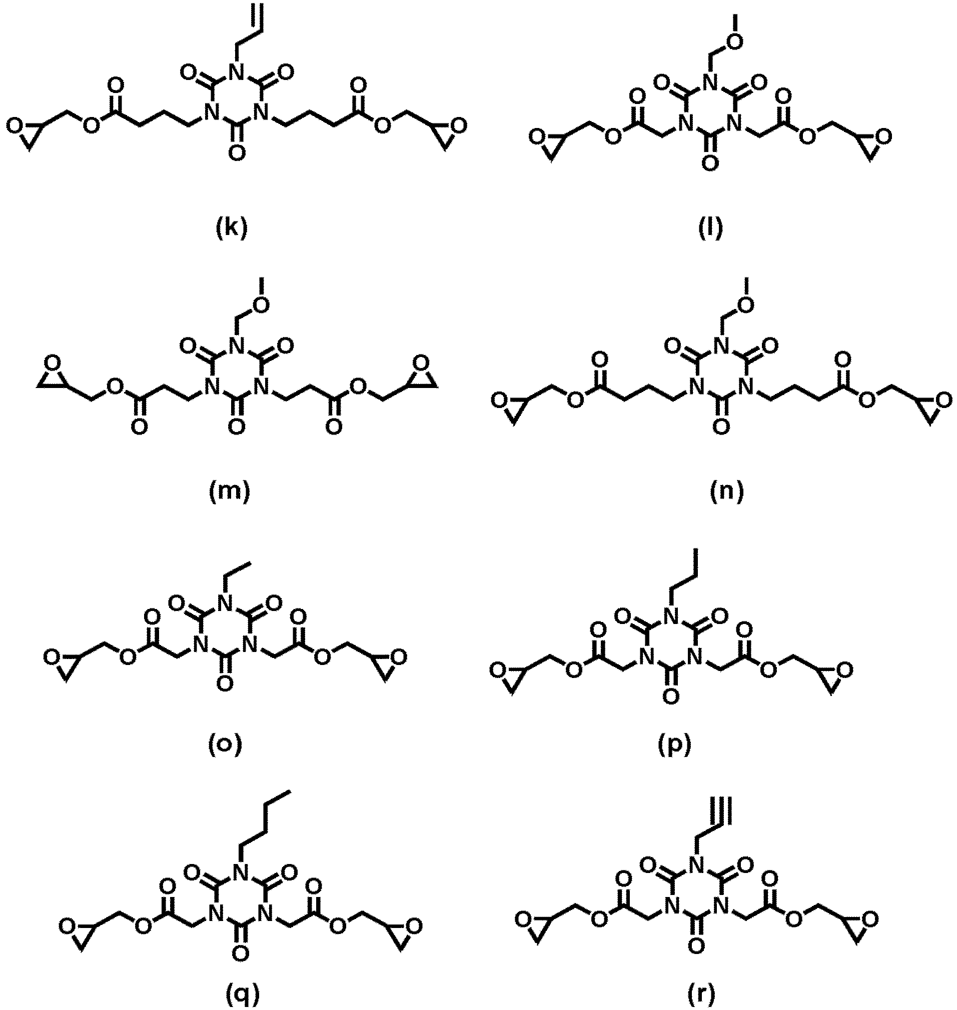

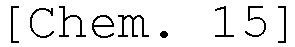

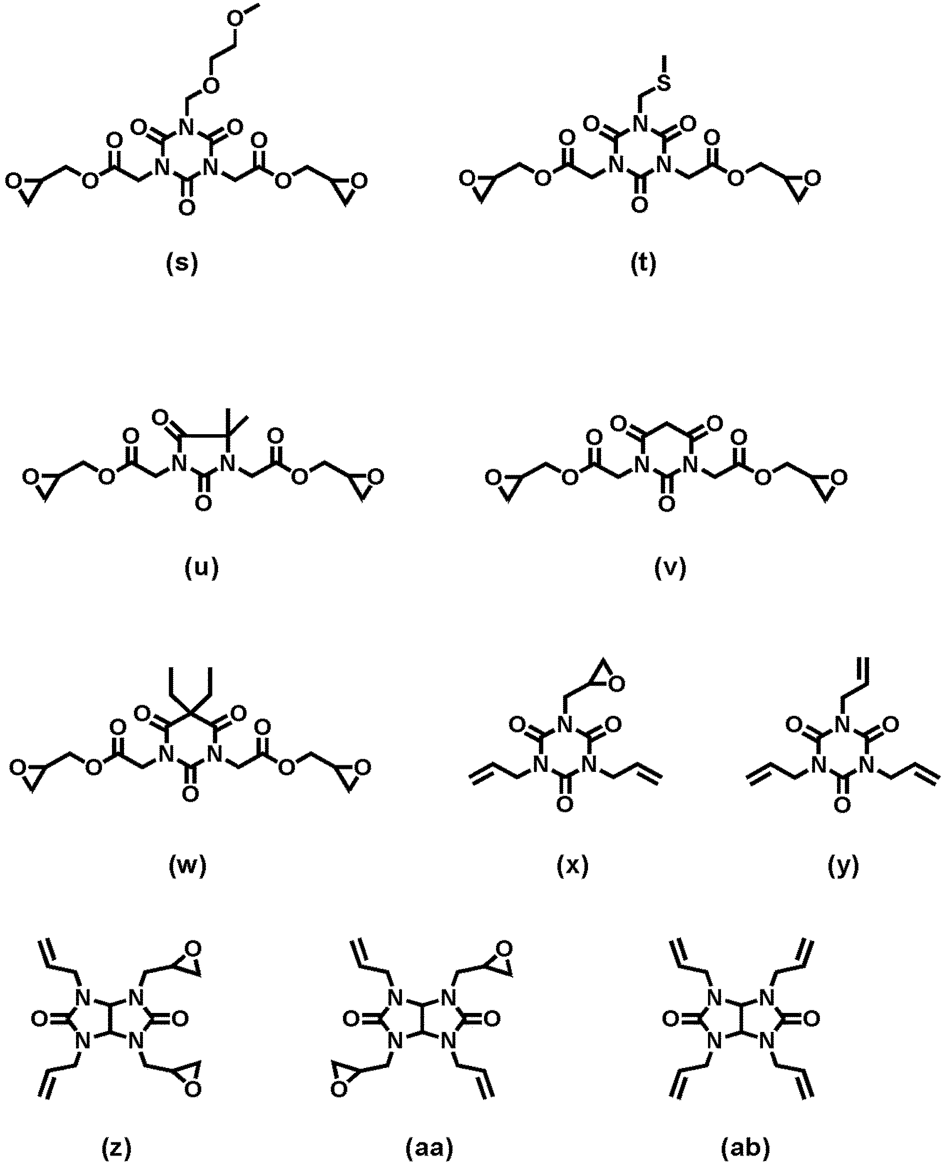

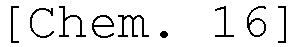

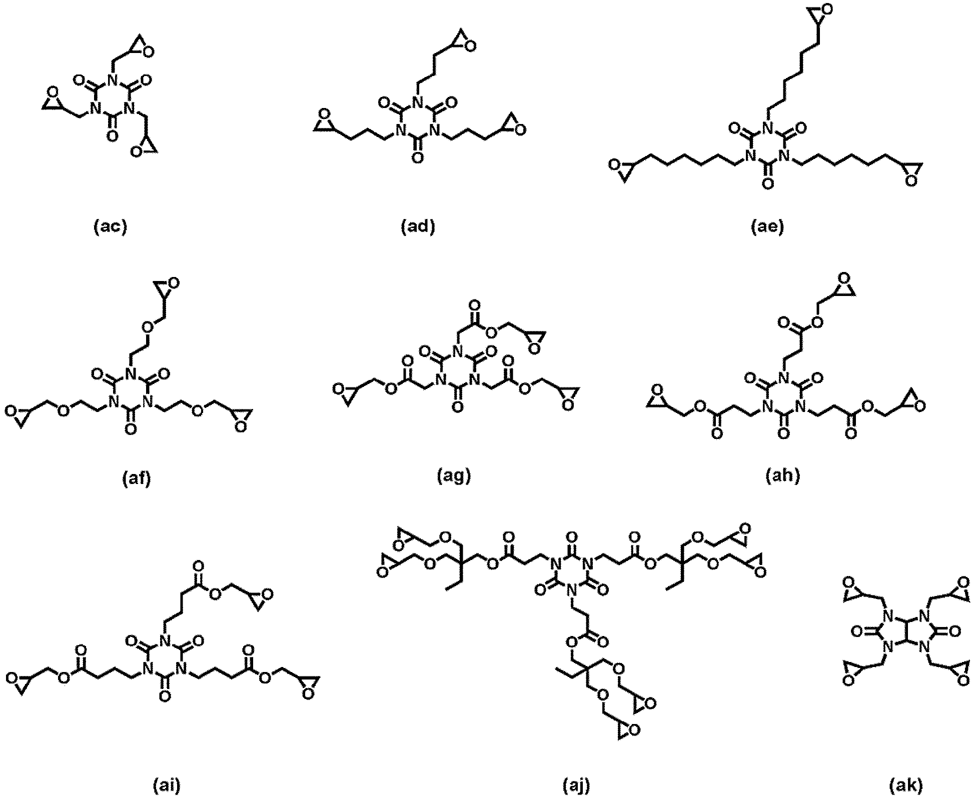

Specific examples of the compound represented by Formula (1) are as follows. The synthesis method will be described in detail in the section of Examples.
· Theoretical molecular weight of the compound represented by Formula (X-1): 799
· Theoretical molecular weight of the compound represented by Formula (X-2): 621
· Theoretical molecular weight of the compound represented by Formula (X-3): 471
· Theoretical molecular weight of the compound represented by Formula (X-4): 499
· Theoretical molecular weight of the compound represented by Formula (X-5): 456
· Theoretical molecular weight of the compound represented by Formula (X-6): 573
· Theoretical molecular weight of the compound represented by Formula (X-7): 795

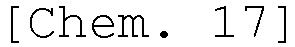

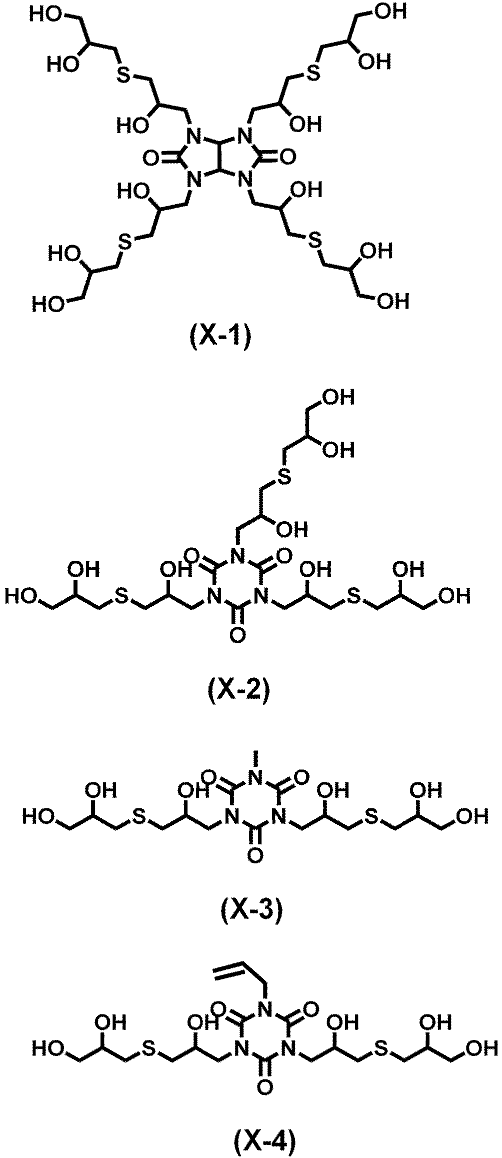

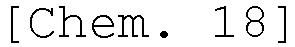

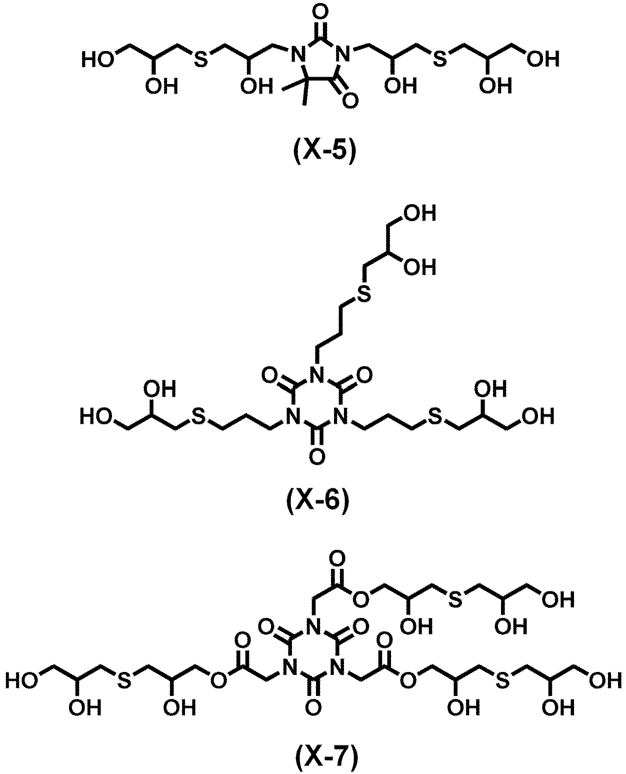

The theoretical molecular weight of the compound represented by Formula (1) is 400 to 999 and preferably 450 to 800.

### <Component (B)>

The component (B) is at least one of a triazole compound (B-1), a tetrazole compound (B-2), a compound (B-3) having two or more phenolic hydroxy groups, and a compound (B-4) having two or more non-phenolic hydroxy groups.

### <<Triazole Compound (B-1)>>

The triazole compound (B-1) is not particularly limited as long as it is a compound having a triazine ring.

The number of triazine rings of the triazole compound (B-1) is not particularly limited, and may be 1, 2, 3, or 4 or more.

The molecular weight of the triazole compound (B-1) is not particularly limited, and may be, for example, 69 to 1,000, 69 to 800, or 69 to 600.

Note that the molecular weight of triazine (C₂H₃N₃) is 69.

The triazole compound (B-1) may be a salt, or need not be a salt.

From the viewpoint of suitably obtaining the effect of the present invention, the triazole compound (B-1) is preferably at least one of a compound represented by the following Formula (B-1-1), a compound represented by the following Formula (B-1-2), a compound represented by the following Formula (B-1-3), and a compound represented by the following Formula (B-1-4): 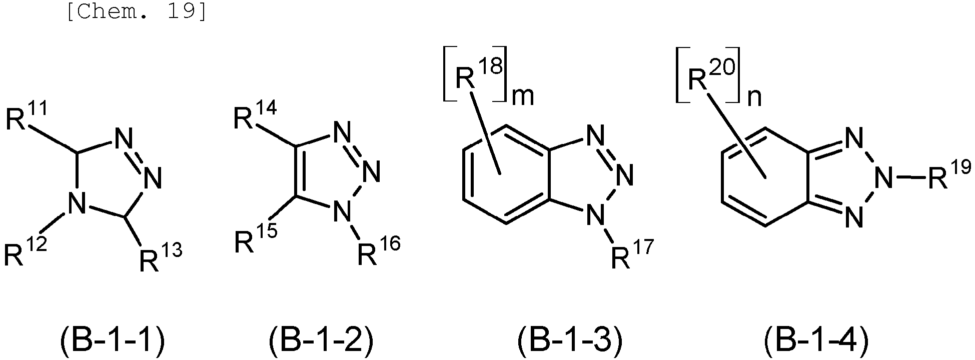
wherein R¹¹ to R²⁰ each independently represent a group formed by one or two or more atoms selected from the group consisting of a hydrogen atom, a carbon atom, an oxygen atom, a nitrogen atom, a sulfur atom, a phosphorus atom, a silicon atom, and a halogen atom,
R¹⁴ and R¹⁵ may be bonded to each other to form a ring structure,
m and n each independently represent an integer of 0 to 4,
when m is 2 or more, two or more R¹⁸s may be the same as or different from each other, and
when n is 2 or more, two or more R²⁰s may be the same as or different from each other.

The molecular weight of R¹¹ to R²⁰ is not particularly limited, and may be, for example, 1 to 500 or 1 to 300.

Examples of the ring structure formed by R¹⁴ and R¹⁵ together include a 5-membered ring and a 6-membered ring.

Examples of the ring structure formed by R¹⁴ and R¹⁵ together include a ring structure having a hetero atom. Examples of the ring structure having a hetero atom include the following ring structures:

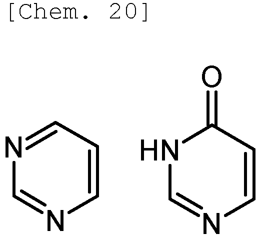

Examples of R¹¹ to R²⁰ include a hydrogen atom, a halogen atom, a hydroxy group, a mercapto group, a carboxy group, an amino group, an amide group, -NO₂, -SO₃H, and a hydrocarbon group which may have a substituent.

Examples of the triazole compound (B-1) include the following compounds:

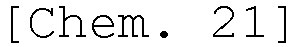

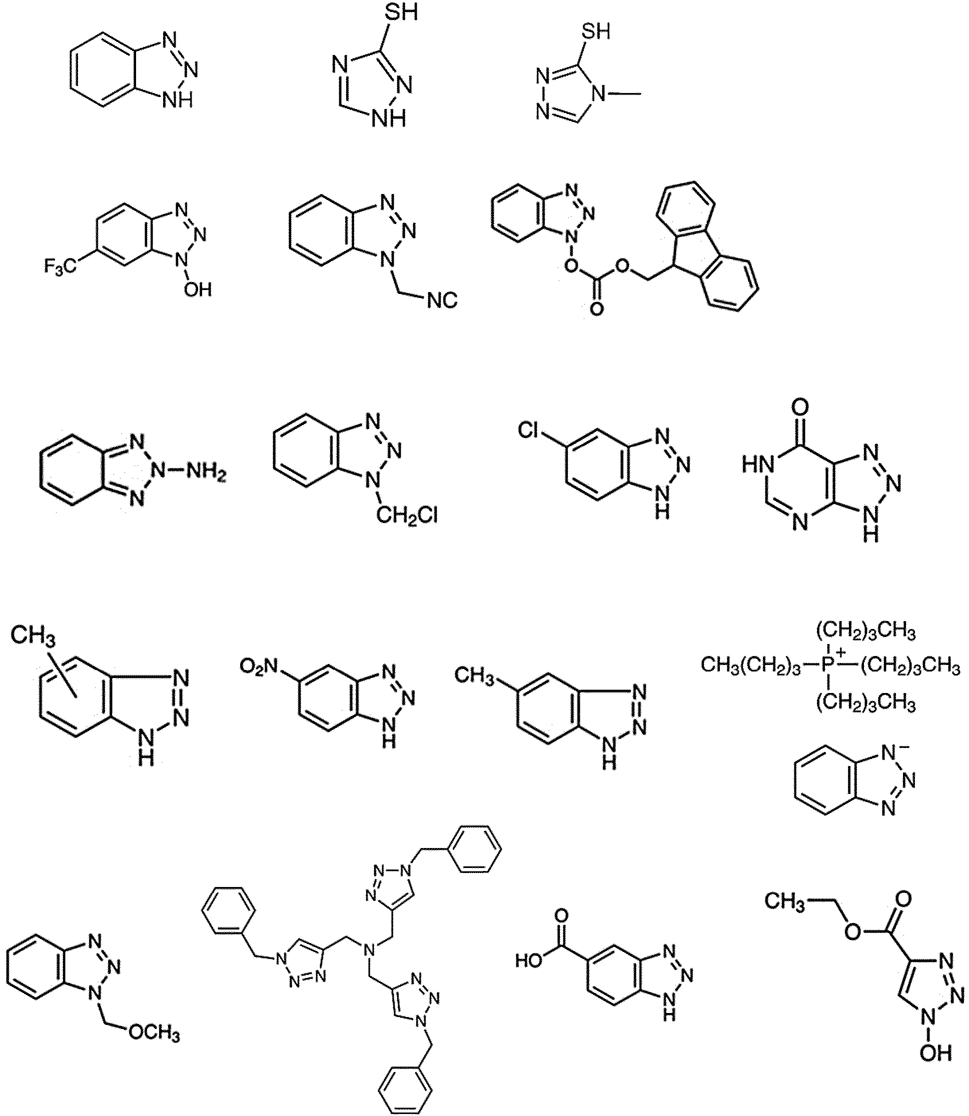

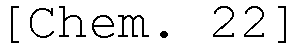

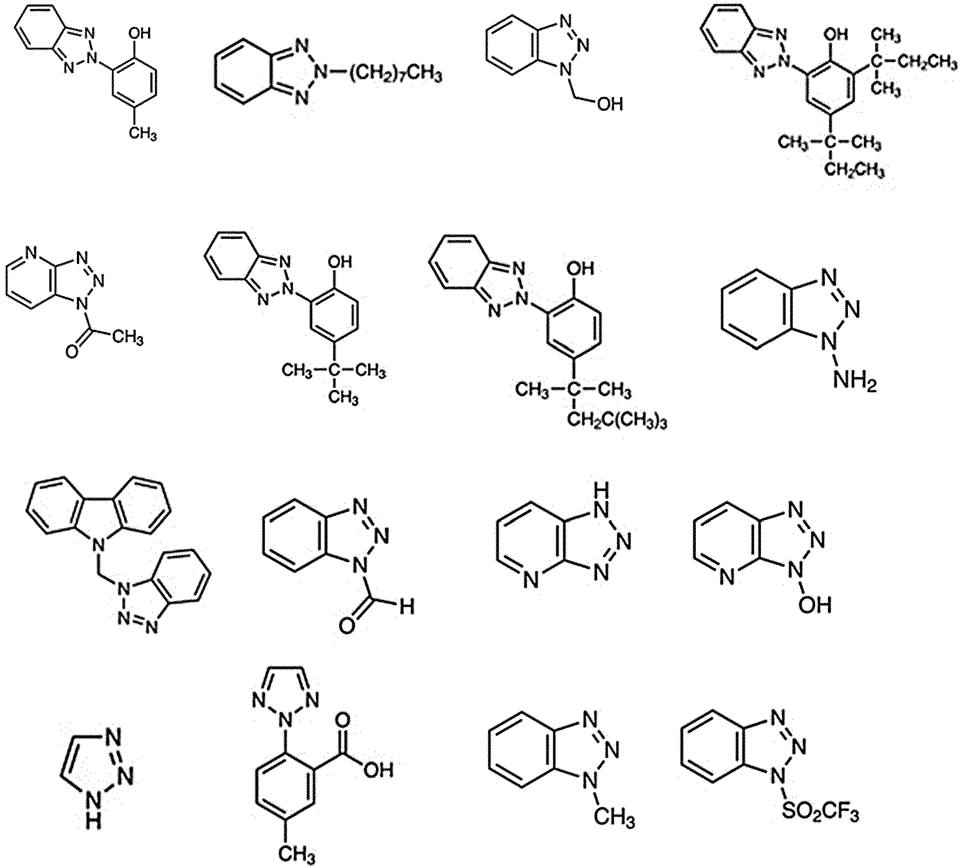

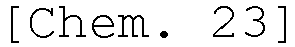

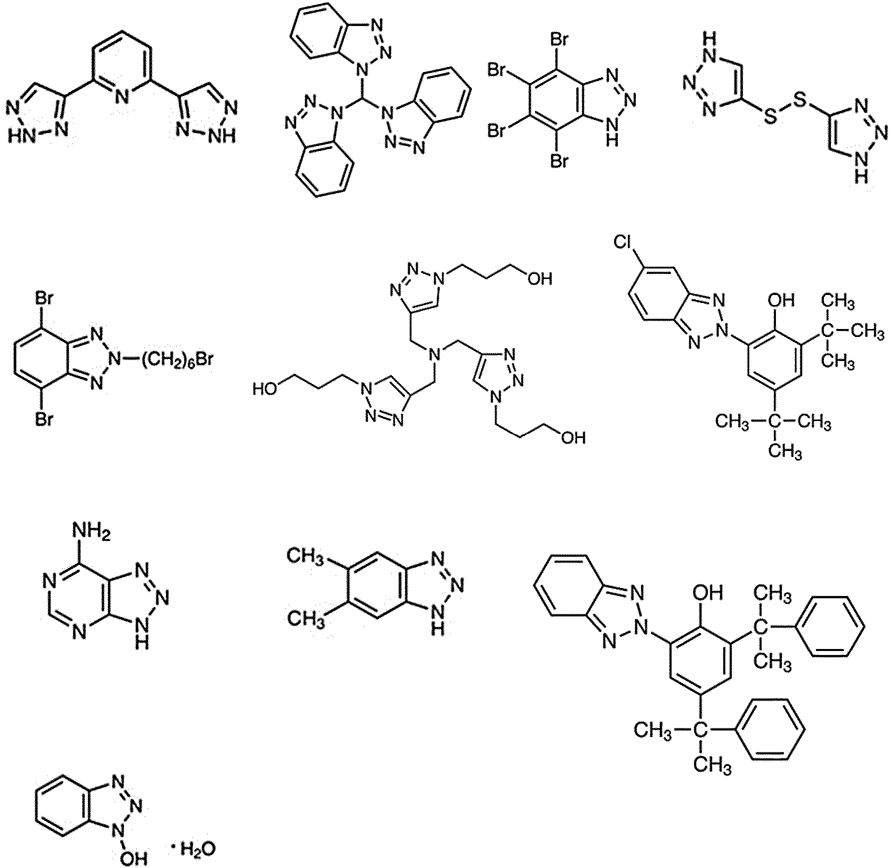

### <<Tetrazole Compound (B-2)>>

The tetrazole compound (B-2) is not particularly limited as long as it is a compound having a tetrazine ring.

The number of tetrazine rings of the tetrazole compound (B-2) is not particularly limited, and may be 1, 2, 3, or 4 or more.

The molecular weight of the tetrazole compound (B-2) is not particularly limited, and may be, for example, 70 to 1,000, 69 to 800, 69 to 600, or 69 to 400.

Note that the molecular weight of tetrazine (CH₂N₄) is 70.

The tetrazole compound (B-2) may be a salt, or need not be a salt.

From the viewpoint of suitably obtaining the effect of the present invention, the tetrazole compound (B-2) is preferably a compound represented by the following Formula (B-2-1): 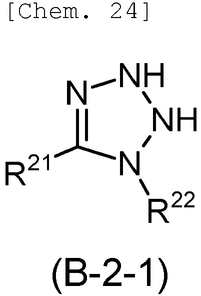
wherein R²¹ and R²² each independently represent a group formed by one or two or more atoms selected from the group consisting of a hydrogen atom, a carbon atom, an oxygen atom, a nitrogen atom, a sulfur atom, a phosphorus atom, a silicon atom, and a halogen atom, and
R²¹ and R²² may be bonded to each other to form a ring structure.

The molecular weight of R²¹ to R²² is not particularly limited, and may be, for example, 1 to 500, and may be 1 to 300.

Examples of the ring structure formed by R²¹ and R²² together include a 5-membered ring, a 6-membered ring, and a 7-membered ring.

Examples of the ring structure formed by R²¹ and R²² together include a ring structure having a hetero atom. Examples of the ring structure having a hetero atom include the following 7-membered ring structures:

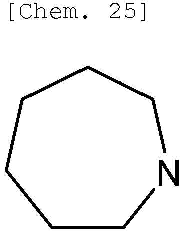

Note that N in the formula is N constituting the tetrazine ring.

Examples of R²¹ and R²² include a hydrogen atom, a halogen atom, a hydroxy group, a mercapto group, a carboxy group, an amino group, an amide group, -NO₂, -SO₃H, and a hydrocarbon group which may have a substituent.

Examples of the tetrazole compound (B-2) include the following compounds:

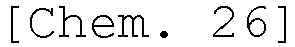

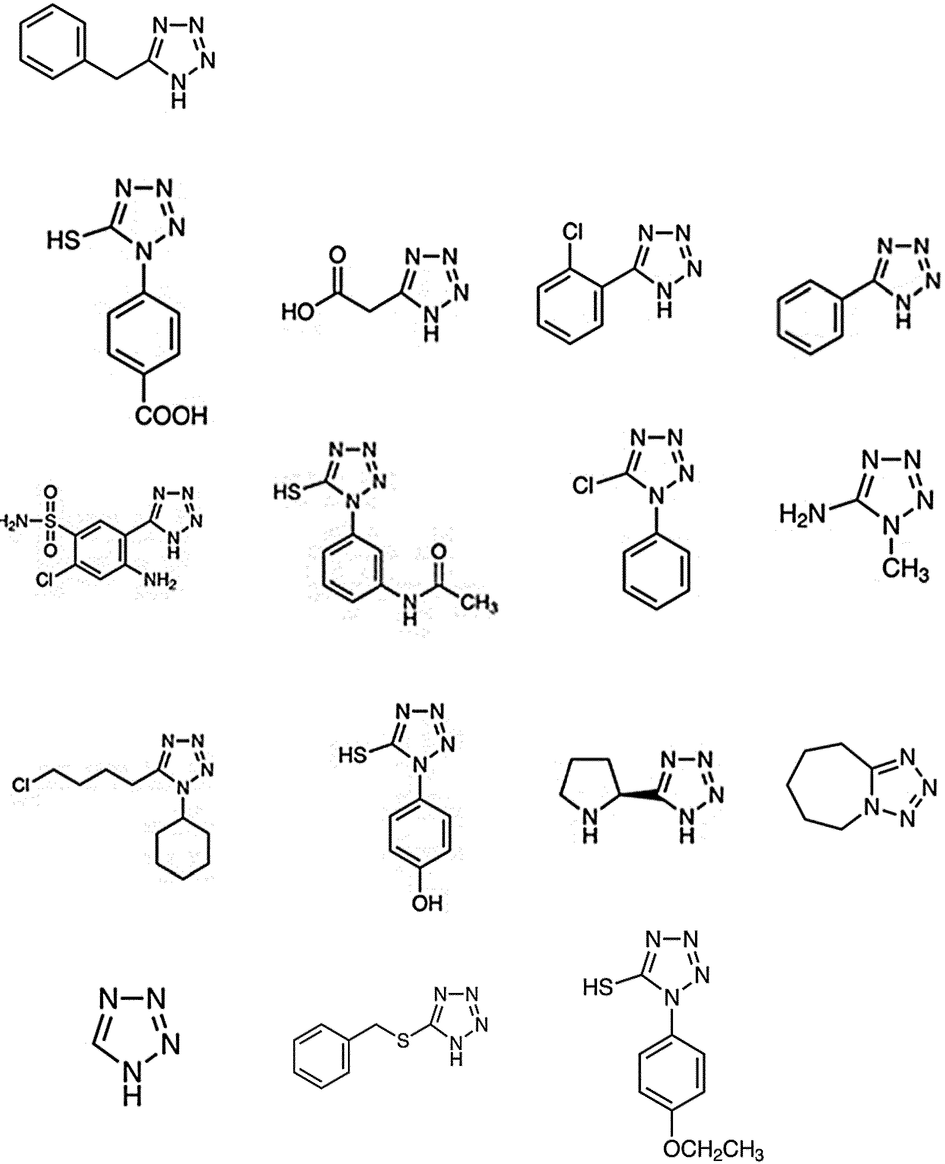

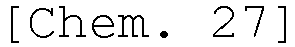

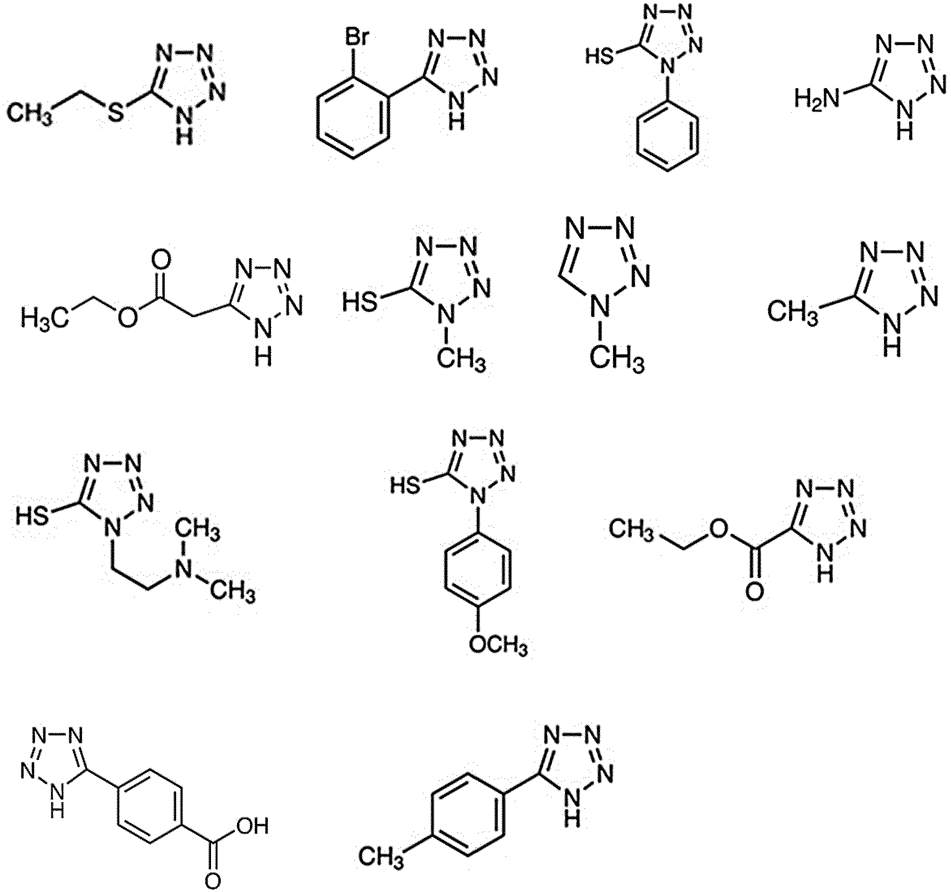

### <<Compound (B-3) Having Two or More Phenolic Hydroxy Groups>>

The compound (B-3) having two or more phenolic hydroxy groups (hereinafter, referred to as the compound (B-3) in some cases) is not particularly limited.

The molecular weight of the compound (B-3) is not particularly limited, and may be, for example, 110 to 1,500, 110 to 1,000, 110 to 800, or 110 to 400.

Note that the molecular weight of dihydroxybenzene is 110.

From the viewpoint of suitably obtaining the effect of the present invention, the compound (B-3) is preferably at least one of a compound (B-3-1) represented by the following Formula (11a), a compound (B-3-2) represented by the following Formula (11b), and a compound (B-3-3) having a group represented by the following Formula (12) and a molecular weight of 300 or more and less than 800 or a compound having a weight average molecular weight of 300 or more and less than 800: 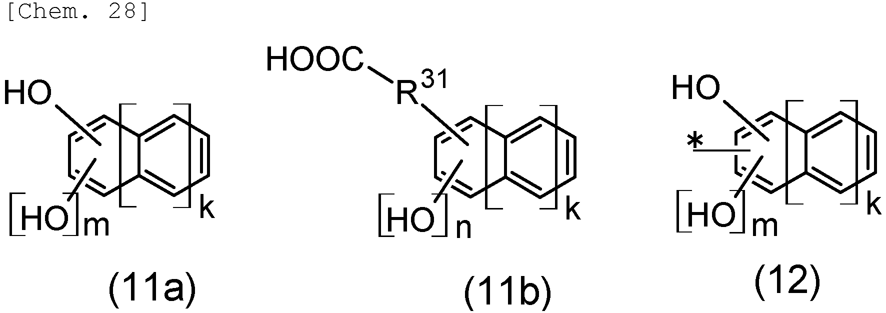
wherein R³¹ represents a single bond, an alkylene group having 1 to 4 carbon atoms, or an alkenylene group having 2 to 4 carbon atoms,
k represents an integer of 0 or 1,
m represents an integer of 1 to 3,
n represents an integer of 2 to 4, and
* represents a bonding hand.

Examples of the compound (B-3-1) represented by Formula (11a) include a compound represented by the following Formula (11a-1) to a compound represented by the following Formula (11a-19):

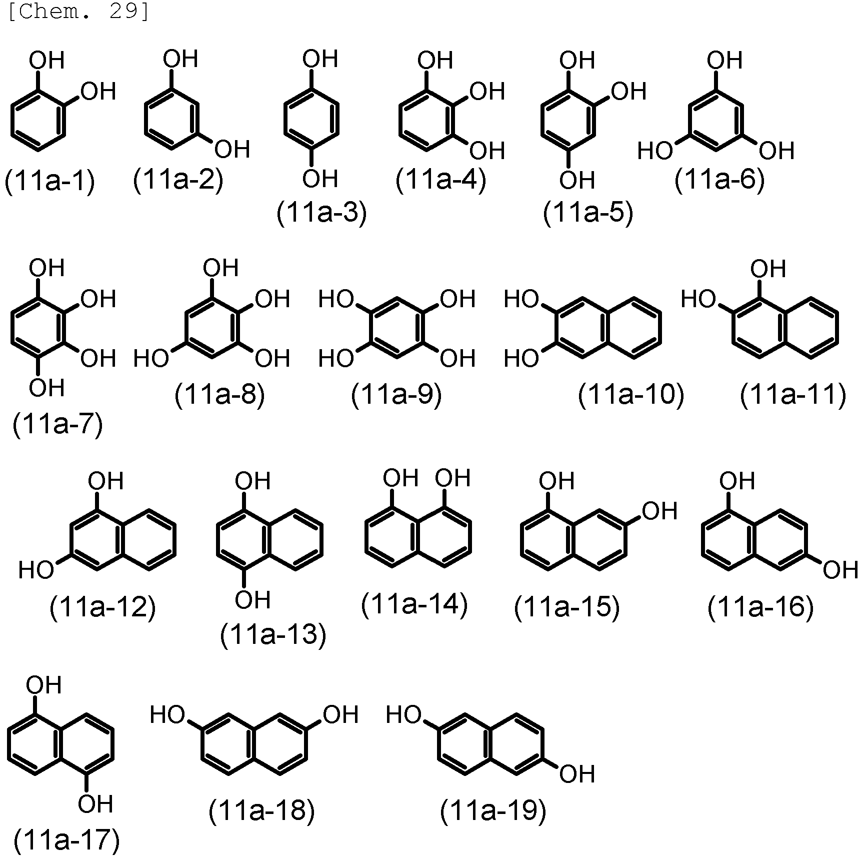

Examples of the compound (B-3-2) represented by Formula (11b) include a compound represented by the following Formula (11b-1) to a compound represented by the following Formula (11b-31):

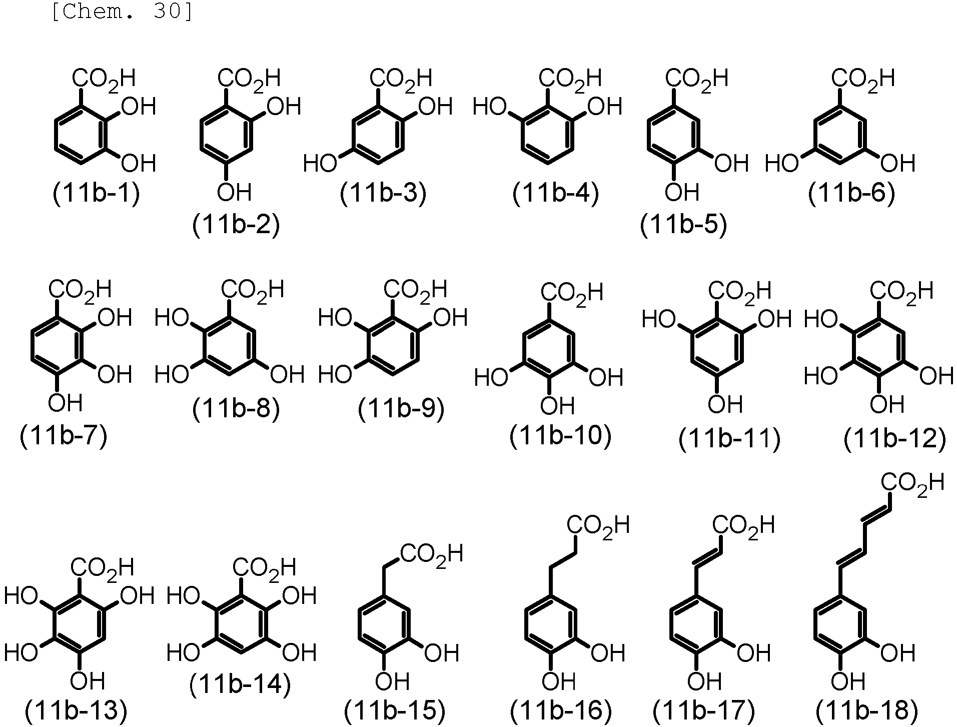

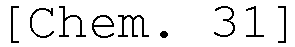

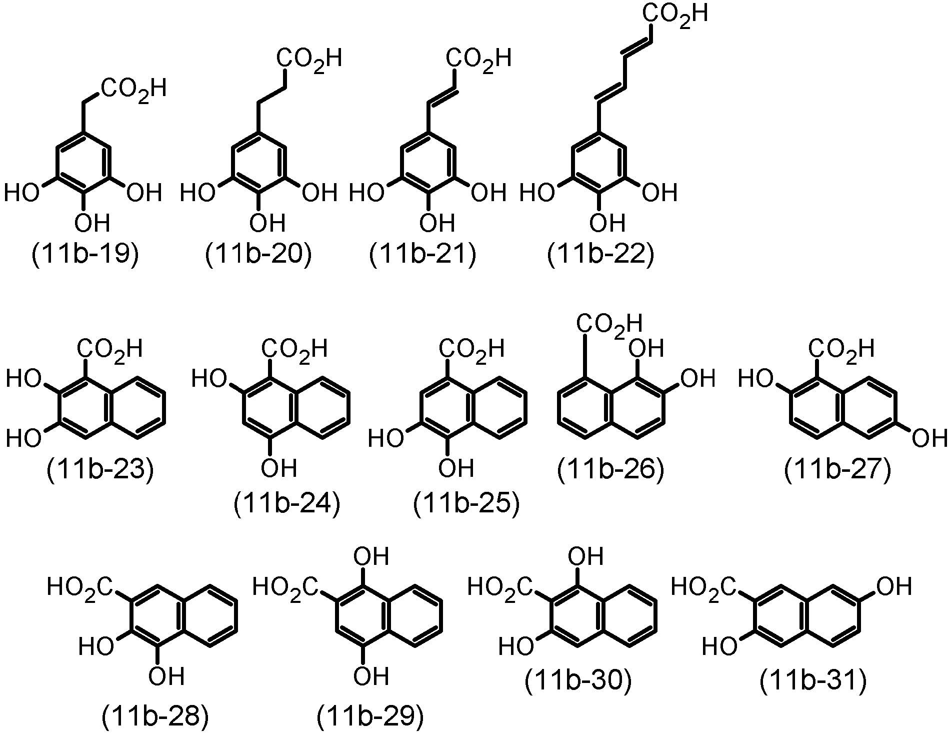

The compound (B-3-3) having a group represented by the following Formula (12) and a molecular weight of 300 or more and less than 800 or a compound having a weight average molecular weight of 300 or more and less than 800 (hereinafter, referred to as the compound (B-3-3) in some cases) may be any of a monomer, a dimer, a trimer, and an oligomer.

Examples of the group represented by Formula (12) include a group represented by the following Formula (21-1) to a group represented by the following Formula (21-14): 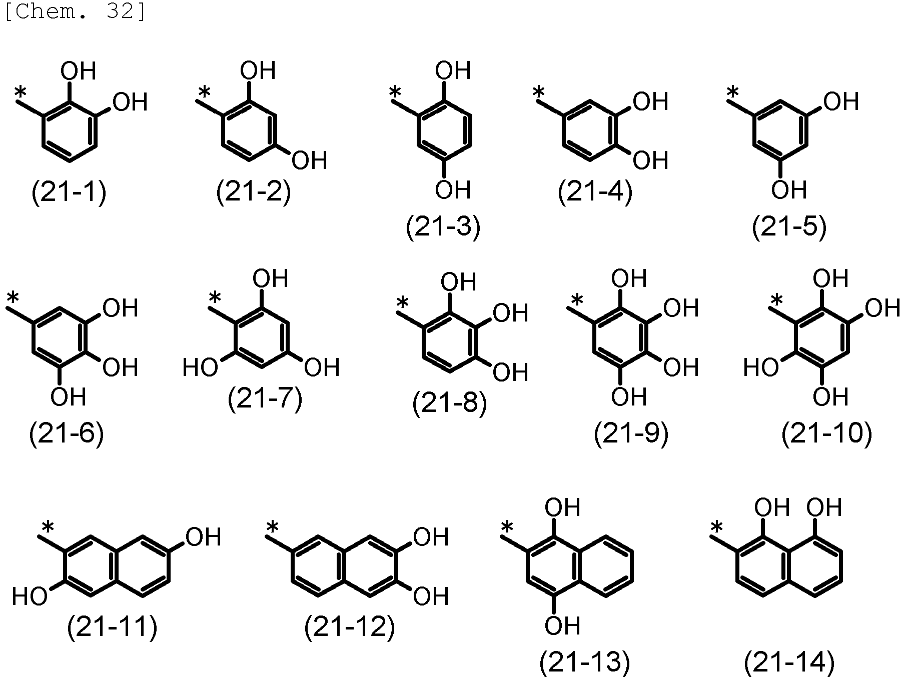 where * represents a bonding hand.

Examples of the compound (B-3-3) include a compound represented by the following Formula (21a-1) to a compound represented by the following Formula (21a-3):

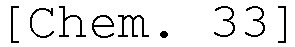

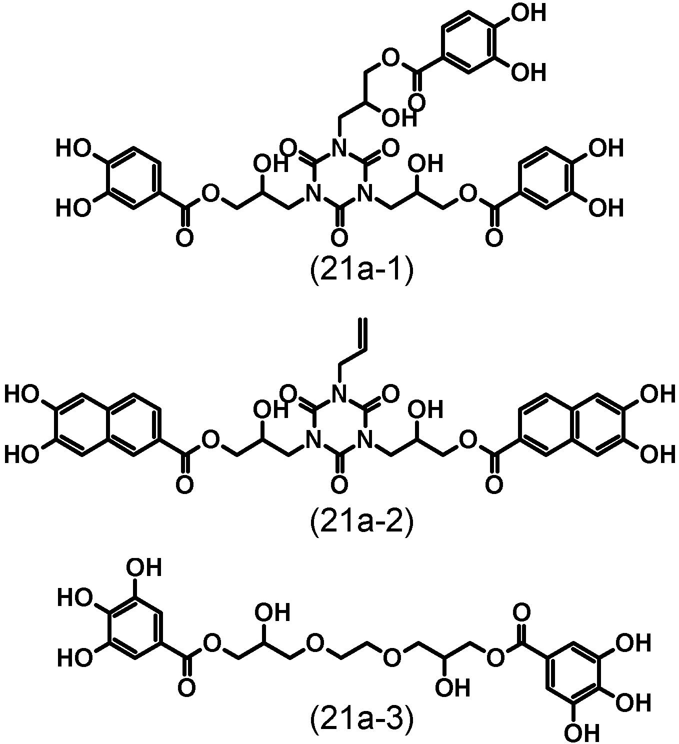

### <<Compound (B-4)) Having Two or More Non-phenolic Hydroxy Groups>>

The compound (B-4) having two or more non-phenolic hydroxy groups (hereinafter, referred to as the compound (B-4) in some cases) is not particularly limited.

The molecular weight of the compound (B-4) is not particularly limited, and may be, for example, 106 to 500, 106 to 400, or 106 to 300.

From the viewpoint of suitably obtaining the effect of the present invention, the compound (B-4) is preferably a compound represented by the following Formula (B-4-1): 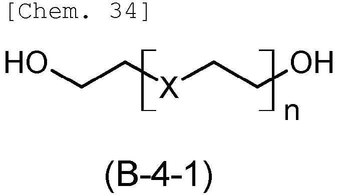
wherein X represents -O- or -NR- (R represents a hydrogen atom, an alkyl group having 1 to 6 carbon atoms which may have a hydroxy group, an aryl group having 6 to 12 carbon atoms which may have a substituent, or an aralkyl group having 7 to 13 carbon atoms which may have a substituent), and
n represents an integer of 1 to 3, and when n is 2 or 3, Xs may be the same as or different from each other.

Examples of the aromatic ring in the aryl group having 6 to 12 carbon atoms, which may have a substituent, include a benzene ring and a naphthalene ring.

Examples of the aromatic ring in the aralkyl group having 7 to 13 carbon atoms, which may have a substituent, include a benzene ring and a naphthalene ring.

Examples of the substituents in the aryl group having 6 to 12 carbon atoms, which may have a substituent, and the aralkyl group having 7 to 13 carbon atoms, which may have a substituent, include an alkyl group having 1 to 6 carbon atoms and an alkoxy group having 1 to 6 carbon atoms.

R in -NR- of Formula (B-4-1) is preferably an alkyl group having 1 to 6 carbon atoms, which may have a hydroxy group, or an aryl group having 6 to 12 carbon atoms, which may have a substituent. As the alkyl group having 1 to 6 carbon atoms, which may have a hydroxy group, a hydroxyalkyl group is preferable, and a 2-hydroxyethyl group is more preferable.

In Formula (B-4-1), when X is -O-, n is preferably 2.

In Formula (B-4-1), when X is -NR-, n is preferably 1.

Examples of the compound (B-4) include the following compounds:

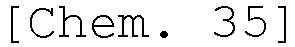

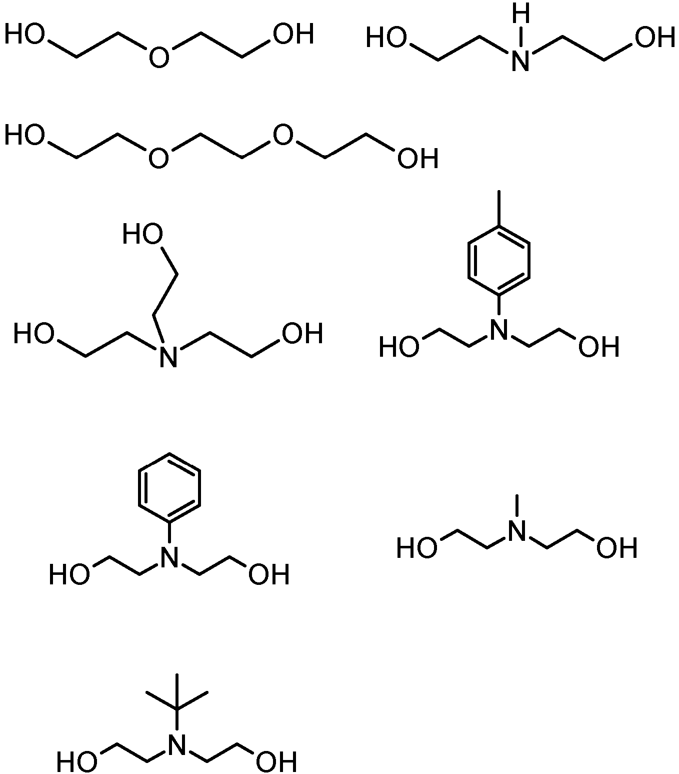

The content of the component (B) in the protective-film forming composition is not particularly limited, and is preferably 0.01 parts by mass to 50 parts by mass, more preferably 0.1 parts by mass to 10 parts by mass and particularly preferably 0.5 parts by mass to 5 parts by mass, with respect to 100 parts by mass of the component (A), from the viewpoint of suitably obtaining the effect of the present invention.

### <Curing Catalyst>

As the curing catalyst contained as an optional component in the protective-film forming composition, both a thermal acid generator and a photoacid generator can be used, but it is preferable to use a thermal acid generator.

Examples of the thermal acid generator include sulfonic acid compounds and carboxylic acid compounds such as p-toluenesulfonic acid, trifluoromethanesulfonic acid, pyridinium-p-toluenesulfonate (pyridinium-p-toluenesulfonic acid), pyridinium phenol sulfonic acid, pyridinium-p-hydroxybenzenesulfonic acid (pyridinium p-phenolsulfonic acid salt), pyridinium-trifluoromethanesulfonic acid, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, and hydroxybenzoic acid.

Examples of the photoacid generator include onium salt compounds, sulfonimide compounds, and disulfonyldiazomethane compounds.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compound include N-(trifluoromethanesulfonyloxy)succinimide, N-(nonafluoro-normal-butanesulfonyloxy)succinimide, N-(camphorsulfonyloxy)succinimide, and N-(trifluoromethanesulfonyloxy)naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

Only one kind of curing catalyst can be used, or two or more kinds thereof can be used in combination.

In the case of using the curing catalyst, the content ratio of the curing catalyst is, for example, 0.1 mass% to 50 mass%, and preferably 1 mass% to 30 mass% with respect to the component (A).

### <(C) Solvent>

The protective-film forming composition of the present invention can be prepared by dissolving the respective components described above in a solvent, preferably in an organic solvent, and is used in a uniform solution state.

The organic solvent of the protective-film forming composition according to the present invention can be used without particular limitation as long as it is an organic solvent capable of dissolving solid components such as the component (A), the component (B), and other optional solid components. In particular, since the protective-film forming composition according to the present invention is used in a uniform solution state, it is recommended to use an organic solvent generally used in a lithography process in combination in consideration of application performance thereof.

Examples of the organic solvent include ethylene glycol monomethyl ether, ethylene glycol monoethyl ether, methyl cellosolve acetate, ethyl cellosolve acetate, diethylene glycol monomethyl ether, diethylene glycol monoethyl ether, propylene glycol, propylene glycol monoethyl ether, propylene glycol monomethyl ether, propylene glycol monomethyl ether acetate, propropylene glycol propyl ether acetate, toluene, xylene, methyl ethyl ketone, methyl isobutyl ketone, cyclopentanone, cyclohexanone, cycloheptanone, 4-methyl-2-pentanol, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, 2-heptanone, methoxycyclopentane, anisole, γ-butyrolactone, N-methylpyrrolidone, N,N-dimethylformamide, and N,N-dimethylacetamide. These solvents can be used singly or in combination of two or more kinds thereof.

Among these solvents, propylene glycol monomethyl ether, propylene glycol monomethyl ether acetate, cyclohexanone, and the like are preferable. In particular, propylene glycol monomethyl ether and propylene glycol monomethyl ether acetate are preferable.

A solid content of the protective-film forming composition according to the present invention is usually 0.1 to 70 mass%, and preferably 0.1 to 60 mass%. The solid content is the content ratio of all components excluding the solvent from the protective-film forming composition. The proportion of the component (A) in the solid content is preferably 1 to 99.9 mass%, more preferably 50 to 99.9 mass%, still more preferably 50 to 95 mass%, and particularly preferably 50 to 90 mass%.

### (Protective Film, Method for Manufacturing Substrate with Protective Film, Method for Manufacturing Substrate with Resist Pattern, and Method for Manufacturing Semiconductor Device)

A protective film of the present invention includes a baked product of a coating film formed of a protective-film forming composition.

The method for manufacturing a substrate with a protective film of the present invention includes a step of applying the protective-film forming composition of the present invention on a stepped semiconductor substrate and baking the protective-film forming composition to form a protective film.

The method for manufacturing a substrate with a resist pattern according to the present invention includes the following steps (1) and (2).

Step (1): a step of applying the protective-film forming composition of the present invention on a semiconductor substrate and baking the protective-film forming composition to form a protective film as a resist underlayer film

Step (2): a step of forming a resist film directly on the protective film or over the protective film, with another layer interposed between the resist film and the protective film, and exposing and developing the resist film to form a resist pattern

A method for manufacturing a semiconductor device according to the present invention includes the following processes (A) to (D).

Process (A): a process of forming a protective film by using the protective-film forming composition of the present invention on a semiconductor substrate having a surface on which an inorganic film is formed

Process (B): a process of forming a resist pattern directly on the protective film or over the protective film, with another layer interposed between the resist pattern and the protective film

Process (C): a process of dry etching the protective film by using the resist pattern as a mask to expose a surface of the inorganic film

Process (D): a process of wet etching the inorganic film by using the protective film after dry etching as a mask with a semiconductor wet etching solution

Examples of the semiconductor substrate onto which the protective-film forming composition (resist underlayer-film forming composition) of the present invention is applied include a silicon wafer, a germanium wafer, and a semiconductor wafer formed of a compound such as gallium arsenide, indium phosphide, gallium nitride, indium nitride, or aluminum nitride.

In the case of using a semiconductor substrate having a surface on which an inorganic film is formed, the inorganic film is formed with, for example, an atomic layer deposition (ALD) method, a chemical vapor deposition (CVD) method, a reactive sputtering method, an ion plating method, a vacuum deposition method, or a spin coating method (spin-on-glass: SOG). Examples of the inorganic film include a polysilicon film, a silicon oxide film, a silicon nitride film, a silicon oxynitride film, a boro-phospho silicate glass (BPSG) film, a titanium nitride film, a titanium oxynitride film, a tungsten nitride film, a gallium nitride film, and a gallium arsenide film.

The semiconductor substrate may be a stepped substrate in which so-called vias (holes), trenches (grooves), and the like are formed. For example, the via has a substantially circular shape when viewed from an upper surface, a substantially circular diameter of the via is, for example, 2 nm to 20 nm, a depth of the via is 50 nm to 500 nm, a width of the groove (a recess of the substrate) of the trench is, for example, 2 nm to 20 nm, and a depth of the trench is 50 nm to 500 nm. Since the protective-film forming composition (resist underlayer-film forming composition) of the present invention has a small weight average molecular weight and average particle size of the compound contained in the composition, the composition can be embedded even in the stepped substrate as described above without a defect such as a void. It is an important characteristic that there are no defects such as voids for the next step (wet etching and dry etching of semiconductor substrate, the formation of a resist pattern) of semiconductor manufacturing.

The protective-film forming composition of the present invention is applied onto such a semiconductor substrate by an appropriate application method such as a spinner or a coater. Thereafter, the protective film is formed by baking using heating means such as a hot plate. Baking conditions are appropriately selected from a baking temperature of 100°C to 400°C and a baking time of 0.3 minutes to 60 minutes. The baking temperature is preferably 120°C to 350°C and the baking time is preferably 0.5 minutes to 30 minutes, and the baking temperature is more preferably 150°C to 300°C, and the baking time is more preferably 0.8 minutes to 10 minutes. The film thickness of the formed protective film is, for example, 0.001 µm to 10 µm, preferably 0.002 µm to 1 µm, and more preferably 0.005 µm to 0.5 µm. In a case where the temperature during the baking is lower than the above range, crosslinking is insufficient, and it may be difficult to obtain resistance of the formed protective film to a resist solvent or a basic aqueous hydrogen peroxide solution. On the other hand, when the temperature at the time of baking is higher than the range, the protective film may be decomposed by heat.

A resist film is formed directly on the protective film thus formed or over the protective film, with another layer interposed between the resist film and the protective film, and the resist film is then exposed and developed to form a resist pattern.

The exposure is performed through a mask (reticle) for forming a predetermined pattern, and for example, i-rays, KrF excimer laser, ArF excimer laser, extreme ultraviolet rays (EUV), or electron beams (EB) are used. An alkaline developer is used for development, and a development temperature is appropriately selected from 5°C to 50°C, and a development time is appropriately selected from 10 seconds to 300 seconds. As the alkaline developer, for example, it is possible to use alkaline aqueous solutions such as aqueous solutions of inorganic alkalis such as sodium hydroxide, potassium hydroxide, sodium carbonate, sodium silicate, sodium metasilicate, and ammonia solutions, primary amines such as ethylamine and n-propylamine, secondary amines such as diethylamine and din-butylamine, tertiary amines such as triethylamine and methyldiethylamine, alcoholamines such as dimethylethanolamine and triethanolamine, quaternary ammonium salts such as tetramethylammonium hydroxide, tetraethylammonium hydroxide, and choline, cyclic amines such as pyrrole and piperidine, and other alkaline aqueous solutions. Furthermore, it is also possible to add an appropriate amount of alcohols such as isopropyl alcohol or nonionic-based surfactants to the above alkaline aqueous solutions and use the resultant mixture. Among these, as the developers, it is preferable to use quaternary ammonium salts, and still more preferable to use tetramethylammonium hydroxide and choline. Furthermore, surfactants or other additives can be added to these developers. A method can also be used in which an organic solvent such as butyl acetate is used in place of the alkaline developer for development to develop a portion where the alkali dissolution rate of the photoresist is not improved.

Next, the protective film is subjected to dry etching using the formed resist pattern as a mask. At that time, when the inorganic film is formed on the surface of the used semiconductor substrate, the surface of the inorganic film is exposed, and when the inorganic film is not formed on the surface of the used semiconductor substrate, the surface of the semiconductor substrate is exposed.

Further, a desired pattern is formed by wet etching using a semiconductor wet etching solution using the protective film (when a resist pattern remains on the protective film, the resist pattern is also formed on the protective film) after dry etching as a mask.

As the semiconductor wet etching solution, a general chemical for etching a semiconductor wafer can be used, and for example, both an acidic substance and a basic substance can be used.

Examples of the substance exhibiting acidity include hydrogen peroxide, hydrofluoric acid, ammonium fluoride, acidic ammonium fluoride, ammonium hydrogen fluoride, buffered hydrofluoric acid, hydrochloric acid, nitric acid, sulfuric acid, phosphoric acid, and a mixed solution thereof.

Examples of the substance exhibiting basicity include basic hydrogen peroxide water obtained by mixing an organic amine such as ammonia, sodium hydroxide, potassium hydroxide, sodium cyanide, potassium cyanide, or triethanolamine with hydrogen peroxide water to make the pH basic. Specific examples thereof include SC-1 (ammonia-hydrogen peroxide solution). In addition, a substance capable of adjusting a pH to a basic pH, for example, a substance capable of finally adjusting a pH to a basic pH by mixing urea with aqueous hydrogen peroxide and causing thermal decomposition of urea by heating to generate ammonia, can be used as a chemical liquid for wet etching.

Among them, acidic hydrogen peroxide water or basic hydrogen peroxide water is preferable.

These chemicals may contain an additive such as a surfactant.

The temperature during use of the semiconductor wet etching solution is desirably 25°C to 90°C, and more desirably 40°C to 80°C. The wet etching time is desirably 0.5 minutes to 30 minutes, and more desirably 1 minute to 20 minutes.

### Examples

Next, the contents of the present invention will be specifically described with reference to Examples, but the present invention is not limited thereto.

The weight average molecular weights of the reaction products shown in the following Synthesis Examples 1 to 3 in the present specification are the measurement results by gel permeation chromatography (hereinafter, abbreviated as GPC). For the measurement, a GPC apparatus manufactured by Tosoh Corporation was used, and measurement conditions and the like are as follows:
· Column temperature: 40°C
· Solvent: tetrahydroxyfuran (THF)
· Flow rate: 1.0 ml/min
· Standard sample: polystyrene (manufactured by Tosoh Corporation)

### <Synthesis Example 1>

A reaction flask was charged with a mixture prepared by addition of 50.2 g of propylene glycol monomethyl ether to 30.0 g of diglycidyl methyl isocyanurate (product name: MeDGIC, 29.9 weight% propylene glycol monomethyl ether solution, manufactured by Shikoku Chemicals Corporation), 7.9 g of 1-thioglycerol (manufactured by ASAHI KAGAKU KOGYO CO., LTD.), and 0.9 g of tetrabutylphosphonium bromide (manufactured by Hokko Chemical Industry Co., Ltd.), and heated and stirred at 100°C for 16 hours in a nitrogen atmosphere. The obtained reaction product corresponded to Formula (X-1), and the weight average molecular weight Mw thereof measured in terms of polystyrene by GPC was 460.

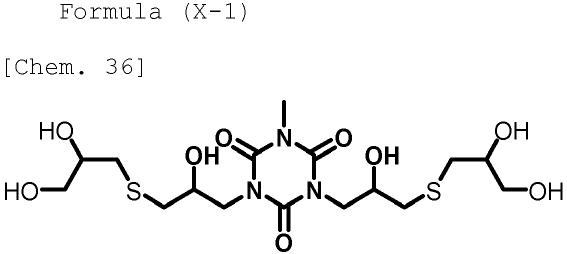

### <Synthesis Example 2>

A reaction flask was charged with a mixture prepared by addition of 67.7 g of propylene glycol monomethyl ether to 9.0 g of monoallyl diglycidyl isocyanurate (product name: MA-DGIC, manufactured by Shikoku Chemicals Corporation), 7.1 g of 1-thioglycerol (manufactured by ASAHI KAGAKU KOGYO CO., LTD.), and 0.82 g of tetrabutylphosphonium bromide (manufactured by Hokko Chemical Industry Co., Ltd.), and heated and stirred at 100°C for 16 hours in a nitrogen atmosphere. The obtained reaction product corresponded to Formula (X-2), and the weight average molecular weight Mw thereof measured in terms of polystyrene by GPC was 491.

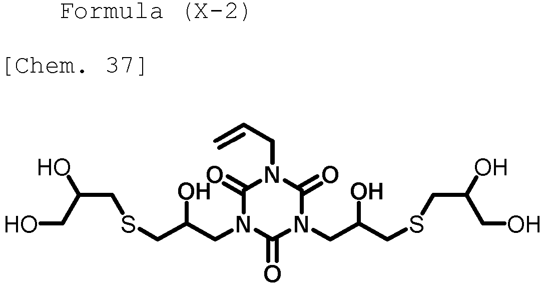

### <Synthesis Example 3>

A reaction flask was charged with a mixture prepared by addition of 115.9 g of propylene glycol monomethyl ether to 13.0 g of triglycidyl isocyanuric acid (product name: TEPIC, manufactured by Nissan Chemical Corporation), 14.3 g of 1-thioglycerol (manufactured by ASAHI KAGAKU KOGYO CO., LTD.), and 1.7 g of tetrabutylphosphonium bromide (manufactured by Hokko Chemical Industry Co., Ltd.), and heated and stirred at 100°C for 16 hours in a nitrogen atmosphere. The obtained reaction product corresponded to Formula (X-3), and the weight average molecular weight Mw thereof measured in terms of polystyrene by GPC was 587.

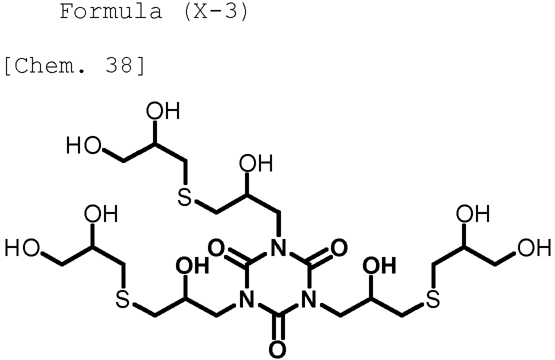

### <Example 1>

To 5.1 g of a solution containing the reaction product obtained in Synthesis Example 1, 0.029 g of pyridinium trifluoromethanesulfonate (manufactured by Tokyo Chemical Industry Co., Ltd.), 0.0076 g of gallic acid hydrate (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 13.0 g of propylene glycol monomethyl ether were added to prepare a solution. The solution was filtered through a polyethylene microfilter having a pore size of 0.02 µm to prepare a protective-film forming composition.

### <Example 2>

To 5.1 g of a solution containing the reaction product obtained in Synthesis Example 1, 0.029 g of pyridinium trifluoromethanesulfonate (manufactured by Tokyo Chemical Industry Co., Ltd.), 0.0076 g of 1,2,3-benzotriazole (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 13.0 g of propylene glycol monomethyl ether were added to prepare a solution. The solution was filtered through a polyethylene microfilter having a pore size of 0.02 µm to prepare a protective-film forming composition.

### <Example 3>

To 5.1 g of a solution containing the reaction product obtained in Synthesis Example 1, 0.029 g of pyridinium trifluoromethanesulfonate (manufactured by Tokyo Chemical Industry Co., Ltd.), 0.0076 g of 5-benzyl-1H-tetrazole (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 13.0 g of propylene glycol monomethyl ether were added to prepare a solution. The solution was filtered through a polyethylene microfilter having a pore size of 0.02 µm to prepare a protective-film forming composition.

### <Example 4>

To 5.1 g of a solution containing the reaction product obtained in Synthesis Example 1, 0.029 g of pyridinium trifluoromethanesulfonate (manufactured by Tokyo Chemical Industry Co., Ltd.), 0.0076 g of triethanolamine (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 13.0 g of propylene glycol monomethyl ether were added to prepare a solution. The solution was filtered through a polyethylene microfilter having a pore size of 0.02 µm to prepare a protective-film forming composition.

### <Example 5>

To 5.1 g of a solution containing the reaction product obtained in Synthesis Example 1, 0.029 g of pyridinium trifluoromethanesulfonate (manufactured by Tokyo Chemical Industry Co., Ltd.), 0.0076 g of N-phenyldiethanolamine (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 13.0 g of propylene glycol monomethyl ether were added to prepare a solution. The solution was filtered through a polyethylene microfilter having a pore size of 0.02 µm to prepare a protective-film forming composition.

### <Example 6>

To 4.9 g of a solution containing the reaction product obtained in Synthesis Example 2, 0.029 g of pyridinium trifluoromethanesulfonate (manufactured by Tokyo Chemical Industry Co., Ltd.), 0.0076 g of gallic acid hydrate (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 13.1 g of propylene glycol monomethyl ether were added to prepare a solution. The solution was filtered through a polyethylene microfilter having a pore size of 0.02 µm to prepare a protective-film forming composition.

### <Example 7>

To 4.9 g of a solution containing the reaction product obtained in Synthesis Example 2, 0.029 g of pyridinium trifluoromethanesulfonate (manufactured by Tokyo Chemical Industry Co., Ltd.), 0.0076 g of 3-mercapto-1,2,4-triazole (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 13.1 g of propylene glycol monomethyl ether were added to prepare a solution. The solution was filtered through a polyethylene microfilter having a pore size of 0.02 µm to prepare a protective-film forming composition.

### <Example 8>

To 4.9 g of a solution containing the reaction product obtained in Synthesis Example 2, 0.029 g of pyridinium trifluoromethanesulfonate (manufactured by Tokyo Chemical Industry Co., Ltd.), 0.0076 g of 3-mercapto-4-methyl-4H-1,2,4-triazole (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 13.1 g of propylene glycol monomethyl ether were added to prepare a solution. The solution was filtered through a polyethylene microfilter having a pore size of 0.02 µm to prepare a protective-film forming composition.

### <Example 9>

To 4.9 g of a solution containing the reaction product obtained in Synthesis Example 2, 0.029 g of pyridinium trifluoromethanesulfonate (manufactured by Tokyo Chemical Industry Co., Ltd.), 0.0076 g of triethanolamine (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 13.1 g of propylene glycol monomethyl ether were added to prepare a solution. The solution was filtered through a polyethylene microfilter having a pore size of 0.02 µm to prepare a protective-film forming composition.

### <Example 10>

To 4.7 g of a solution containing the reaction product obtained in Synthesis Example 3, 0.029 g of pyridinium trifluoromethanesulfonate (manufactured by Tokyo Chemical Industry Co., Ltd.), 0.0076 g of 5-benzyl-1H-tetrazole (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 13.4 g of propylene glycol monomethyl ether were added to prepare a solution. The solution was filtered through a polyethylene microfilter having a pore size of 0.02 µm to prepare a protective-film forming composition.

### <Example 11>

To 4.7 g of a solution containing the reaction product obtained in Synthesis Example 3, 0.029 g of pyridinium trifluoromethanesulfonate (manufactured by Tokyo Chemical Industry Co., Ltd.), 0.0076 g of N-phenyldiethanolamine (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 13.4 g of propylene glycol monomethyl ether were added to prepare a solution. The solution was filtered through a polyethylene microfilter having a pore size of 0.02 µm to prepare a protective-film forming composition.

### <Comparative Example 1>

To 5.1 g of a solution containing the reaction product obtained in Synthesis Example 1, 0.029 g of pyridinium trifluoromethanesulfonate (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 12.9 g of propylene glycol monomethyl ether were added to prepare a solution. The solution was filtered through a polyethylene microfilter having a pore size of 0.02 µm to prepare a protective-film forming composition.

### <Comparative Example 2>

To 5.0 g of a solution containing the reaction product obtained in Synthesis Example 2, 0.029 g of pyridinium trifluoromethanesulfonate (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 13.0 g of propylene glycol monomethyl ether were added to prepare a solution. The solution was filtered through a polyethylene microfilter having a pore size of 0.02 µm to prepare a protective-film forming composition.

### <Comparative Example 3>

To 4.7 g of a solution containing the reaction product obtained in Synthesis Example 3, 0.029 g of pyridinium trifluoromethanesulfonate (manufactured by Tokyo Chemical Industry Co., Ltd.), 0.0008 g of a surfactant (product name: MEGAFACE R-40, manufactured by DIC Corporation), 1.9 g of propylene glycol monomethyl ether acetate, and 13.3 g of propylene glycol monomethyl ether were added to prepare a solution. The solution was filtered through a polyethylene microfilter having a pore size of 0.02 µm to prepare a protective-film forming composition.

### <Comparative Example 4>

To 8.25 g of a solution of a reaction product obtained by the method described in Synthesis Example 12 of WO2020/026834 (a copolymer corresponding to Formula (1n) and having a weight average molecular weight of 4500 as measured in terms of polystyrene by GPC) (solid content: 16.4 mass%), 0.05 g of pyridinium trifluoromethanesulfonate (manufactured by Tokyo Chemical Industry Co., Ltd.), 0.01 g of a surfactant (product name: MEGAFACE R-40, manufactured by DIC Corporation), 18.05 g of propylene glycol monomethyl ether, and 2.84 g of propylene glycol monomethyl ether acetate were added to prepare a solution. The solution was filtered through a polyethylene microfilter having a pore size of 0.02 µm to prepare a protective-film forming composition.

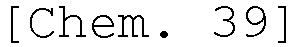

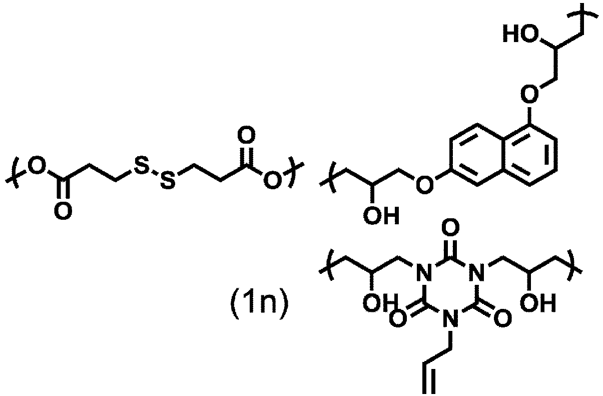

The names, abbreviations, and structures of the additives used in Examples 1 to 11 are shown below.

### · Gallic acid (GA)

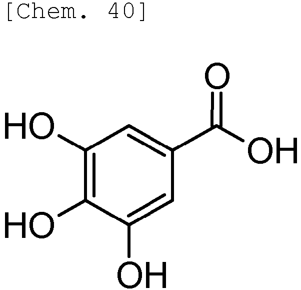

### · 1,2,3-Benzotriazole (BTZ)

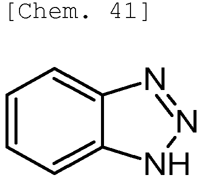

### · 5-Benzyl-1H-tetrazole (5-BTEZ)

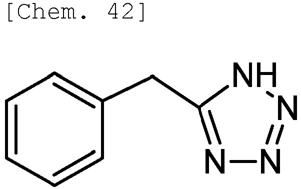

### · Triethanolamine (TEA)

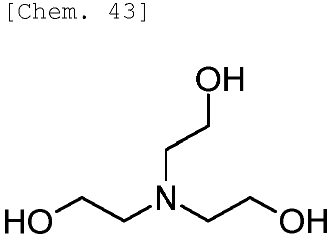

### · N-Phenyldiethanolamine (PDEA)

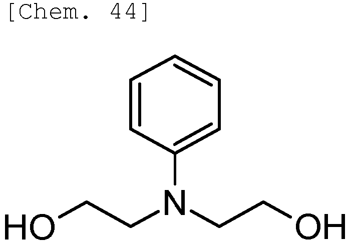

### · 3-Mercapto-1,2,4-triazole (3-MTZ)

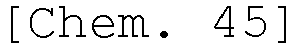

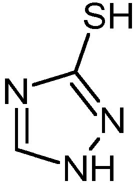

### · 3-Mercapto-4-methyl-4H-1,2,4-triazole (3-MMTZ)

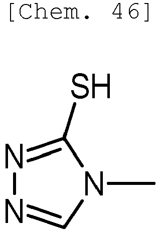

The type of the reaction product, the type of the additive, and the blending amount of the additive in Examples 1 to 11 and Comparative Examples 1 to 3 are shown in Table 1. Note that the blending amount of the additive in Table 1 is the blending amount (parts by mass) with respect to 100 parts by mass of the reaction product.

**[Table 1]**

| | Reaction product | Additive | |
|---|---|---|---|
| | | Type | Blending amount (parts by mass) |
| Example 1 | Synthesis Example 1 | GA | 1 |
| Example 2 | Synthesis Example 1 | BTZ | 1 |
| Example 3 | Synthesis Example 1 | 5-BTEZ | 1 |
| Example 4 | Synthesis Example 1 | TEA | 1 |
| Example 5 | Synthesis Example 1 | PDEA | 1 |
| Example 6 | Synthesis Example 2 | GA | 1 |
| Example 7 | Synthesis Example 2 | 3-MTZ | 1 |
| Example 8 | Synthesis Example 2 | 3-MMTZ | 1 |
| Example 9 | Synthesis Example 2 | TEA | 1 |
| Example 10 | Synthesis Example 3 | 5-BTEZ | 1 |
| Example 11 | Synthesis Example 3 | PDEA | 1 |
| Comparative Example 1 | Synthesis Example 1 | - | - |
| Comparative Example 2 | Synthesis Example 2 | - | - |
| Comparative Example 3 | Synthesis Example 3 | - | - |

### (Formation of Coating Film)

### [Resistance Test to Hydrogen Peroxide Water]

As an evaluation of resistance to hydrogen peroxide water, each of the protective-film forming compositions prepared in Examples 1 to 11 and Comparative Examples 1 to 4 was applied onto a substrate having 50 nm thick titanium nitride (TiN) deposited, and heated at 220°C for 1 minute to form a protective film having a film thickness of 100 nm. Next, 20 mass% hydrogen peroxide water was prepared. The TiN deposited substrate applied with the protective-film forming composition was immersed in the 20 mass% hydrogen peroxide water heated to 70°C, and the time from immediately after the immersion until the coating film (protective film) was peeled off was measured. The results of the resistance test to hydrogen peroxide water are shown in Tables 2-1 and 2-2. "○" in Tables 2-1 and 2-2 indicates a state in which peeling was not observed in the coating film even after immersion, and "×" indicates a state in which peeling was observed in a part or all of the coating film after immersion.

**[Table 2-1]**

| | Reaction product | Result of resistance test for 7 minutes |
|---|---|---|
| Example 1 | Synthesis Example 1 | ○ |
| Example 2 | Synthesis Example 1 | ○ |
| Example 3 | Synthesis Example 1 | ○ |
| Example 4 | Synthesis Example 1 | ○ |
| Example 5 | Synthesis Example 1 | ○ |
| Example 6 | Synthesis Example 2 | ○ |
| Example 7 | Synthesis Example 2 | ○ |
| Example 8 | Synthesis Example 2 | ○ |
| Example 9 | Synthesis Example 2 | ○ |
| Comparative Example 1 | Synthesis Example 1 | × |
| Comparative Example 2 | Synthesis Example 2 | × |
| Comparative Example 4 | Formula (1n) | × (peeled off at 2 minutes) |

**[Table 2-2]**

| | Reaction product | Result of resistance test for 15 minutes |
|---|---|---|
| Example 10 | Synthesis Example 3 | ○ |
| Example 11 | Synthesis Example 3 | ○ |
| Comparative Example 3 | Synthesis Example 3 | × |
| Comparative Example 4 | Formula (1n) | × (peeled off at 2 minutes) |

From the results in Tables 2-1 and 2-2, it was shown that the coating films produced using the protective-film forming compositions prepared in Examples 1 to 11 have sufficient resistance to hydrogen peroxide water. That is, it was found that these coating films can serve as a protective film against hydrogen peroxide water.

### (Test of Optical Parameters)

Each of the protective-film forming compositions prepared in Examples 1 to 11 and Comparative Examples 1 and 4 was applied onto a silicon wafer with a spinner. Baking was performed on a hot plate at 220°C for 1 minute to form a protective film (film thickness: 50 nm). Then, an n value (a refractive index) and a k value (an attenuation coefficient or an absorption coefficient) of these films at a wavelength of 193 nm and a wavelength of 248 nm were measured using a spectroscopic ellipsometer (J.A. Woollam Company, VUV-VASE VU-302). The results are shown in Table 3.

**[Table 3]**

| | n/k@193 nm | n/k@248 nm |
|---|---|---|
| Example 1 | 1.93/0.27 | 1.70/0 |
| Example 2 | 1.94/0.28 | 1.71/0 |
| Example 3 | 1.94/0.28 | 1.71/0 |
| Example 4 | 1.94/0.27 | 1.70/0 |
| Example 5 | 1.94/0.27 | 1.70/0 |
| Example 6 | 1.96/0.29 | 1.71/0 |
| Example 7 | 1.96/0.29 | 1.71/0 |
| Example 8 | 1.96/0.29 | 1.71/0 |
| Example 9 | 1.96/0.28 | 1.71/0 |
| Example 10 | 1.90/0.24 | 1.71/0 |
| Example 11 | 1.91/0.24 | 1.72/0 |
| Comparative Example 1 | 1.94/0.27 | 1.71/0 |
| Comparative Example 2 | 1.96/0.29 | 1.71/0 |
| Comparative Example 3 | 1.91/0.24 | 1.72/0 |
| Comparative Example 4 | 1.84/0.24 | 1.74/0.14 |

### [Evaluation of Etching Selection Ratio]

As an evaluation of the etching selection ratio, each of the resist underlayer-film forming compositions (protective-film forming compositions) prepared in Examples 1 to 11 and Comparative Examples 1 to 4 described above was applied onto a silicon wafer, and heated at 220°C for 1 minute to form a protective film having a film thickness of 100 nm. Next, the formed protective film was dry-etched with a mixed gas of nitrogen gas and hydrogen gas using a dry etching apparatus (product name: Lam2300, manufactured by Lam research) to measure a ratio of the dry etching rate of the protective film (selection ratio of the dry etching rate). The measurement results of the etching selection ratio are shown in Table 4. It can be said that the higher the etching selection ratio, the higher the dry etching rate. Note that the results shown in Table 4 are the etching rates when the etching rate of the protective film of Comparative Example 4 is 1.0.

**[Table 4]**

| | Etching selection ratio (H2N2 gas condition) |
|---|---|
| Example 1 | 1.4 |
| Example 2 | 1.4 |
| Example 3 | 1.4 |
| Example 4 | 1.4 |
| Example 5 | 1.5 |
| Example 6 | 1.4 |
| Example 7 | 1.2 |
| Example 8 | 1.2 |
| Example 9 | 1.2 |
| Example 10 | 1.4 |
| Example 11 | 1.4 |
| Comparative Example 1 | 1.4 |
| Comparative Example 2 | 1.2 |
| Comparative Example 3 | 1.4 |
| Comparative Example 4 | 1.0 |

From the above results, it can be said that Examples 1 to 11 have a higher dry etching selection ratio than Comparative Example 4, and thus have a higher dry etching rate. That is, Examples 1 to 11 are useful because the dry etching time required to remove the protective film can be shortened, so that damage to the base substrate can be reduced.

### Industrial Applicability

The protective-film forming composition according to the present invention has excellent resistance when a wet etching solution is applied in substrate processing and has a high dry etching rate so as to provide a protective film with which substrate processing is easy.

## Claims

1. A protective-film forming composition against a semiconductor wet etching solution, comprising:
component (A): a film-forming component;
component (B): at least one of a triazole compound (B-1), a tetrazole compound (B-2), a compound (B-3) having two or more phenolic hydroxy groups, and a compound (B-4) having two or more non-phenolic hydroxy groups; and
component (C): a solvent.

2. The protective-film forming composition according to claim 1, wherein the component (A) includes a compound having a theoretical molecular weight of 999 or less.

3. The protective-film forming composition according to claim 2, wherein the compound having a theoretical molecular weight of 999 or less is a compound having a theoretical molecular weight of 999 or less represented by the following Formula (1): 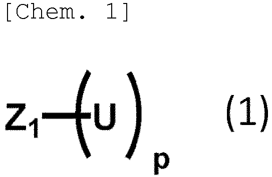
wherein Z₁ represents a p-valent group containing a nitrogen-containing heterocyclic ring,
p represents an integer of 2 to 4, and
each U independently represents a monovalent organic group represented by the following Formula (2), 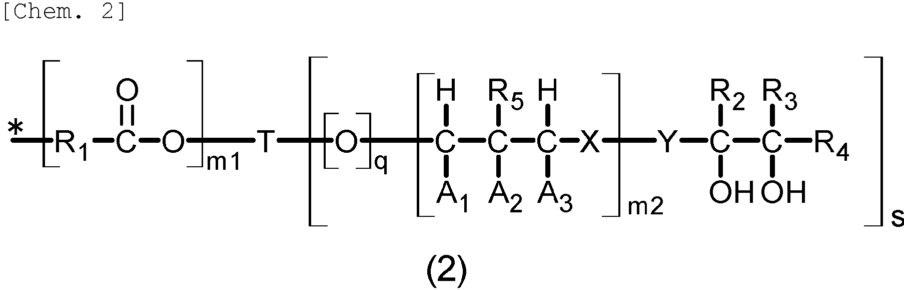
wherein R₁ represents an alkylene group having 1 to 4 carbon atoms,
T represents a single bond or a (s+1)-valent hydrocarbon group having 1 to 8 carbon atoms,
A₁ to A₃ each independently represent a hydrogen atom, a methyl group, or an ethyl group,
X represents -COO-, -OCO-, -O-, -S-, or -NRₐ-, and Rₐ represents a hydrogen atom or a methyl group,
Y represents a single bond or an alkylene group having 1 to 4 carbon atoms which may be substituted,
R₂, R₃, and R₄ each independently represent a hydrogen atom or an alkyl group having 1 to 10 carbon atoms or an aryl group having 6 to 40 carbon atoms which may be substituted,
R₅ represents a hydrogen atom or a hydroxy group,
m1, m2, and q each independently represent an integer of 0 or 1,
s represents an integer of 1 or 2, and
* represents a bonding moiety to Z₁ in Formula (1),
provided that, when T is a single bond, m1 and q are not simultaneously 1.

4. The protective-film forming composition according to claim 3, wherein Z₁ is represented by the following Formula (3-1) or (3-2): 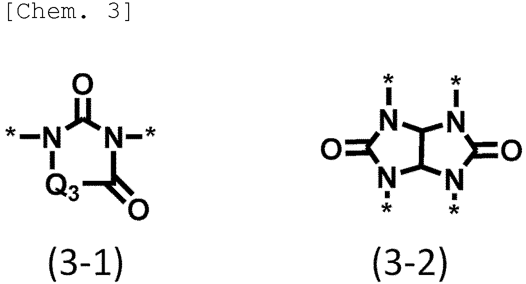
wherein Q₃ represents the following Formula (4), (5), (6), or (7), and
each * represents a bonding moiety to U in Formula (1), 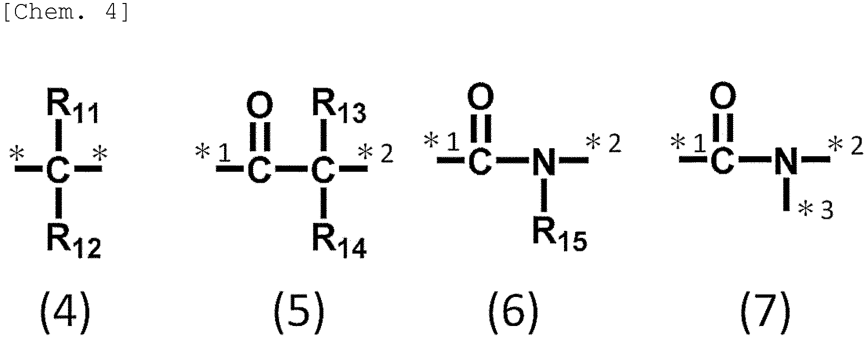
wherein R₁₁ to R₁₅ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, and the phenyl group may be substituted with at least one monovalent functional group selected from the group consisting of an alkyl group having 1 to 6 carbon atoms, a halogen atom, an alkoxy group having 1 to 10 carbon atoms, a nitro group, a cyano group, and an alkylthio group having 1 to 6 carbon atoms,
* represents a bonding hand, *1 represents a bonding hand bonded to a nitrogen atom in Formula (3-1), *2 represents a bonding hand bonded to a carbon atom in Formula (3-1), and *3 represents a bonding moiety to U in Formula (1).

5. The protective-film forming composition according to claim 1, wherein the triazole compound (B-1) is at least one of a compound represented by the following Formula (B-1-1), a compound represented by the following Formula (B-1-2), a compound represented by the following Formula (B-1-3), and a compound represented by the following Formula (B-1-4): 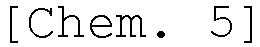 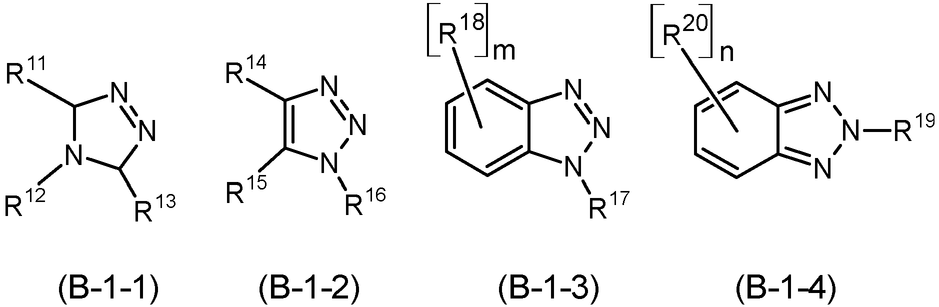
wherein R¹¹ to R²⁰ each independently represent a group formed by one or two or more atoms selected from the group consisting of a hydrogen atom, a carbon atom, an oxygen atom, a nitrogen atom, a sulfur atom, a phosphorus atom, a silicon atom, and a halogen atom,
R¹⁴ and R¹⁵ may be bonded to each other to form a ring structure,
m and n each independently represent an integer of 0 to 4,
when m is 2 or more, two or more R¹⁸s may be the same as or different from each other, and
when n is 2 or more, two or more R²⁰s may be the same as or different from each other.

6. The protective-film forming composition according to claim 1, wherein the tetrazole compound (B-2) is a compound represented by the following Formula (B-2-1): 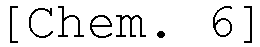 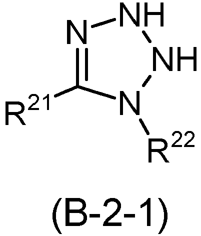
wherein R²¹ and R²² each independently represent a group formed by one or two or more atoms selected from the group consisting of a hydrogen atom, a carbon atom, an oxygen atom, a nitrogen atom, a sulfur atom, a phosphorus atom, a silicon atom, and a halogen atom, and
R²¹ and R²² may be bonded to each other to form a ring structure.

7. The protective-film forming composition according to claim **1,** wherein the compound (B-3) is at least one of a compound (B-3-1) represented by the following Formula (11a), a compound (B-3-2) represented by the following Formula (11b), and a compound (B-3-3) having a group represented by the following Formula (12) and a molecular weight of 300 or more and less than 800 or a compound having a weight average molecular weight of 300 or more and less than 800: 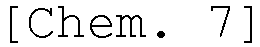 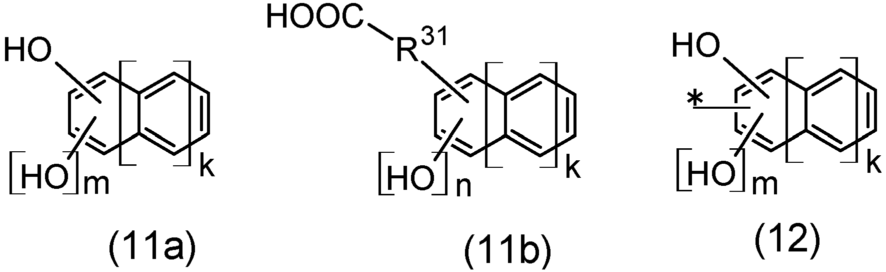
wherein R³¹ represents a single bond, an alkylene group having 1 to 4 carbon atoms, or an alkenylene group having 2 to 4 carbon atoms,
k represents an integer of 0 or 1,
m represents an integer of 1 to 3,
n represents an integer of 2 to 4, and
* represents a bonding hand.

8. The protective-film forming composition according to claim 1, wherein the compound (B-4) having two or more non-phenolic hydroxy groups is a compound represented by the following Formula (B-4-1): 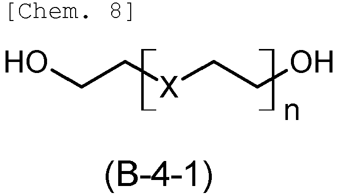
wherein X represents -O- or -NR- (R represents a hydrogen atom, an alkyl group having 1 to 6 carbon atoms which may have a hydroxy group, an aryl group having 6 to 12 carbon atoms which may have a substituent, or an aralkyl group having 7 to 13 carbon atoms which may have a substituent), and
n represents an integer of 1 to 3, and when n is 2 or 3, Xs may be the same as or different from each other.

9. A protective film against a semiconductor wet etching solution, wherein the protective film includes a baked product of a coating film formed of the protective-film forming composition according to any one of claims 1 to 8.

10. A method for manufacturing a substrate with a protective film used in semiconductor manufacturing, the method comprising: a step of applying the protective-film forming composition according to any one of claims 1 to 8 onto a stepped semiconductor substrate and baking the protective-film forming composition to form a protective film.

11. A method for manufacturing a substrate with a resist pattern used in semiconductor manufacturing, the method comprising:
a step of applying the protective-film forming composition according to any one of claims 1 to 8 on a semiconductor substrate and baking the protective-film forming composition to form a protective film as a resist underlayer film; and
a step of forming a resist film directly on the protective film or over the protective film, with another layer interposed between the resist film and the protective film, and exposing and developing the resist film to form a resist pattern.

12. A method for manufacturing a semiconductor device, the method comprising a step of forming a protective film by using the protective-film forming composition according to any one of claims 1 to 8 on a semiconductor substrate having a surface on which an inorganic film is formed, forming a resist pattern directly on the protective film or over the protective film, with another layer interposed between the resist pattern and the protective film, dry etching the protective film by using the resist pattern as a mask to expose a surface of the inorganic film, and performing wet etching on the inorganic film by using the protective film after the dry etching as a mask with a semiconductor wet etching solution.
